# EUROPEAN PATENT APPLICATION

(11) **EP 4 495 992 A1**
(43) Date of publication of application: **22.01.2025**
(21) Application number: 23770479.6
(22) Date of filing: 03.03.2023
(51) Int. Cl.: H01L 23/38, H05K 7/20

(54) **SEMICONDUCTOR DEVICE**

(30) Priority: 15.03.2022 JP 2022040650
(71) Applicant: Sony Semiconductor Solutions Corporation, Atsugi-shi, Kanagawa 243-0014 (JP)
(72) Inventor: YASUKAWA Hirohisa, Atsugi-shi, Kanagawa 243-0014 (JP); ONO Koichi, Tokyo 108-0075 (JP)
(74) Representative: MFG Patentanwälte Meyer-Wildhagen Meggle-Freund Gerhard PartG mbB
(86) International application number: PCT/JP2023/008131
(87) International publication number: WO 2023/176522

(57) **Abstract**

There is provided a semiconductor device that can improve cooling efficiency of Peltier effect elements. A semiconductor device includes: semiconductor elements; Peltier effect elements that are attached to first surfaces of the semiconductor elements without a wiring board; and a package substrate to which the semiconductor elements are attached. A region of the package substrate facing the first surfaces of the semiconductor elements is provided with a first recess or a through hole. The Peltier effect element is disposed in the first recess or in the through hole.

## Description

### [Technical Field]

The present disclosure relates to a semiconductor device.

### [Background Art]

As means for cooling a solid-state imaging element, an airtight sealing package including built-in Peltier effect elements is known (see, for example, PTL 1). The airtight sealing package disclosed in PTL 1 includes Peltier effect elements disposed between the solid-state imaging elements and a protrusion of a base front surface.

### [Citation List]

### [Patent Literature]

[PTL 1]
JP 2003-258221A

### [Summary]

### [Technical Problem]

In a semiconductor device including semiconductor elements (e.g., sensor elements such as image sensors or IC elements), improvement of cooling efficiency of Peltier elements (hereinafter, also referred to as Peltier effect elements) is desired.

With such circumstances in view, an object of the present disclosure is to provide a semiconductor device that can improve cooling efficiency of Peltier effect elements.

### [Solution to Problem]

A semiconductor device according to one aspect of the present disclosure includes: a semiconductor element; a Peltier effect element that is attached to a first surface of the semiconductor element without a wiring substrate; and a package substrate to which the semiconductor element is attached. A region of the package substrate facing the first surface of the semiconductor element is provided with a first recess or a through hole. The Peltier effect element is disposed in the first recess or in the through hole.

Consequently, the Peltier effect elements are accommodated in the first recess or the through hole, so that it is easy to secure the heights of the Peltier effect elements. It is possible to increase a distance between first electrodes that are a heat absorption side and second electrodes that are a heat discharge side, and suppress heat transfer from the heat discharge side to the heat absorption side. Consequently, it is possible to improve cooling efficiency of the Peltier effect elements of cooling the semiconductor element.

A semiconductor device according to another aspect of the present disclosure includes: a semiconductor element; and a Peltier effect element that is attached to a first surface of the semiconductor element without a wiring substrate. The first surface of the semiconductor element is provided with a second recess. The Peltier effect element is disposed in the second recess.

Consequently, the Peltier effect elements are accommodated in the second recess, so that it is easy to secure the heights of the Peltier effect elements. It is possible to increase a distance between first electrodes that are the heat absorption side and second electrodes that are the heat discharge side, and suppress heat transfer from the heat discharge side to the heat absorption side. Consequently, it is possible to improve cooling efficiency of the Peltier effect elements of cooling the semiconductor element.

A semiconductor device according to still another aspect of the present disclosure includes: a semiconductor element; a Peltier effect element that is attached to a first surface of the semiconductor element without a wiring substrate; and a motherboard that faces the semiconductor element with the Peltier effect element interposed therebetween. The motherboard is provided with a third recess. The Peltier effect element is disposed in the third recess.

Consequently, the Peltier effect elements are accommodated in the third recess, so that it is easy to secure the heights of the Peltier effect elements. It is possible to increase a distance between first electrodes that are the heat absorption side and second electrodes that are the heat discharge side, and suppress heat transfer from the heat discharge side to the heat absorption side. Consequently, it is possible to improve cooling efficiency of the Peltier effect elements of cooling the semiconductor element.

### [Brief Description of Drawings]

[Fig. 1]

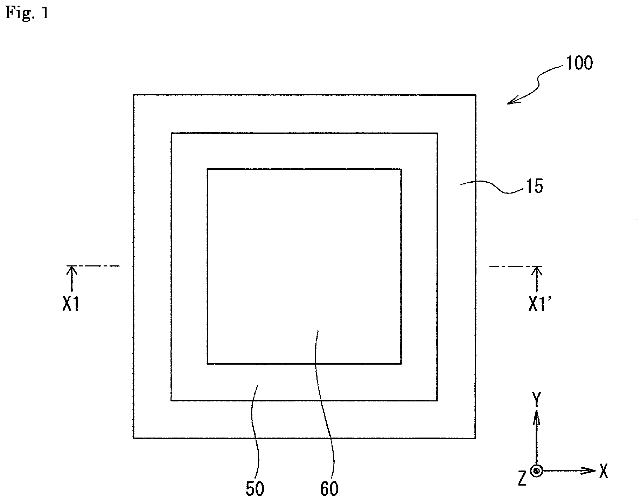

   Fig. 1 is a plan view illustrating a configuration example of a sensor package according to Embodiment 1 of the present disclosure.
[Fig. 2]

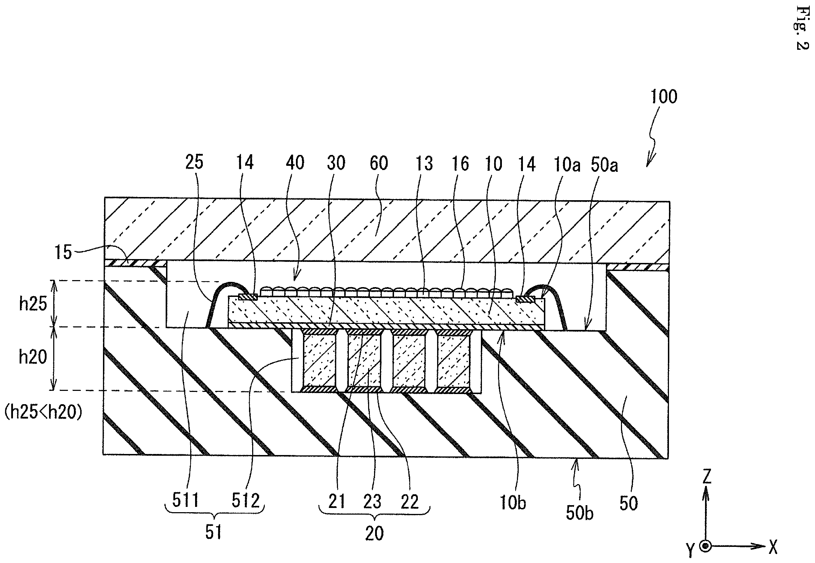

   Fig. 2 is a cross-sectional view illustrating a configuration example of the sensor package according to Embodiment 1 of the present disclosure.
[Fig. 3]

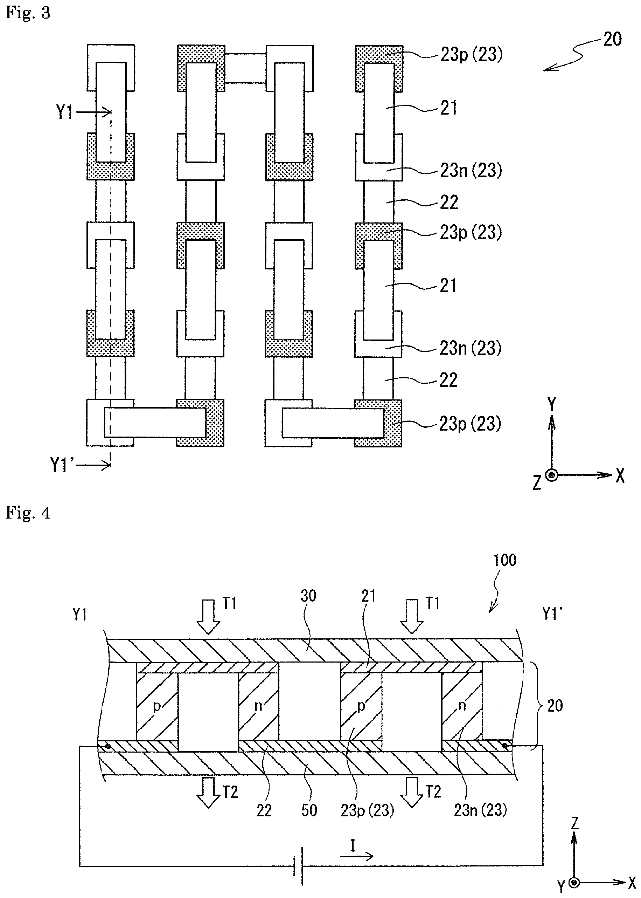

   Fig. 3 is a plan view illustrating a configuration example of Peltier effect elements according to Embodiment 1 of the present disclosure.
[Fig. 4]
   Fig. 4 is a cross-sectional view illustrating the configuration example of the Peltier effect elements according to Embodiment 1 of the present disclosure.
[Fig. 5A]

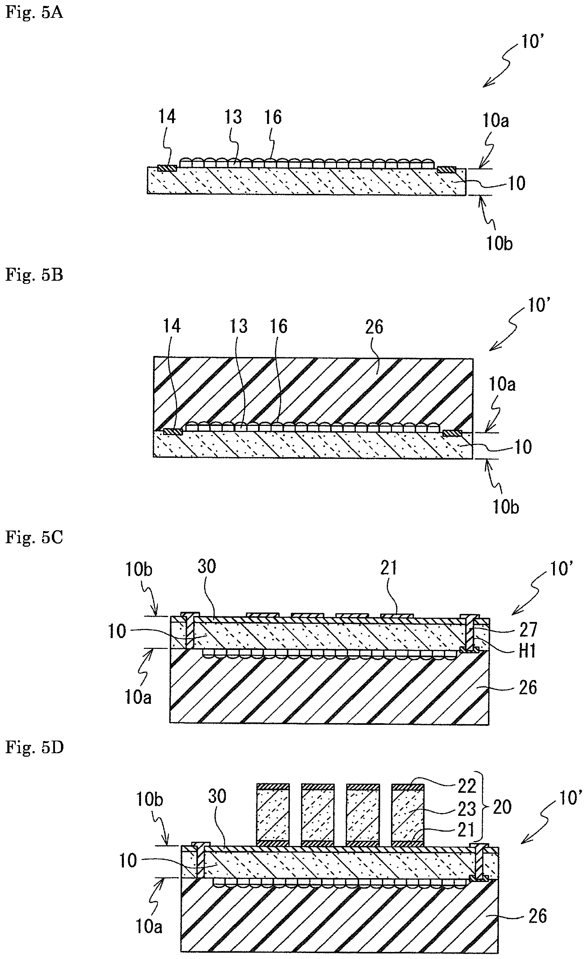

   Fig. 5A is a cross-sectional view illustrating a manufacturing method for the sensor package according to Embodiment 1 of the present disclosure.
[Fig. 5B]
   Fig. 5B is a cross-sectional view illustrating the manufacturing method for the sensor package according to Embodiment 1 of the present disclosure.
[Fig. 5C]
   Fig. 5C is a cross-sectional view illustrating the manufacturing method for the sensor package according to Embodiment 1 of the present disclosure.
[Fig. 5D]
   Fig. 5D is a cross-sectional view illustrating the manufacturing method for the sensor package according to Embodiment 1 of the present disclosure.
[Fig. 5E]

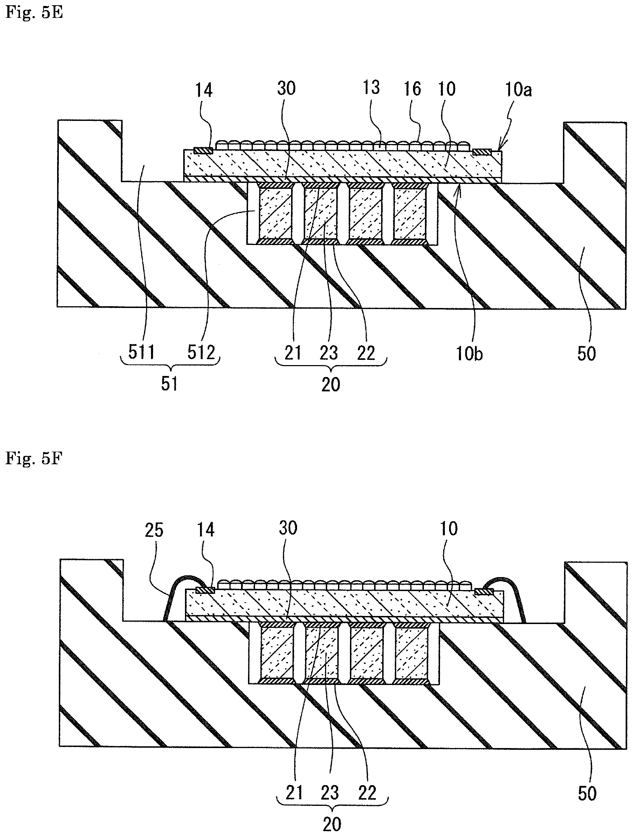

   Fig. 5E is a cross-sectional view illustrating the manufacturing method for the sensor package according to Embodiment 1 of the present disclosure.
[Fig. 5F]
   Fig. 5F is a cross-sectional view illustrating the manufacturing method for the sensor package according to Embodiment 1 of the present disclosure.
[Fig. 6]

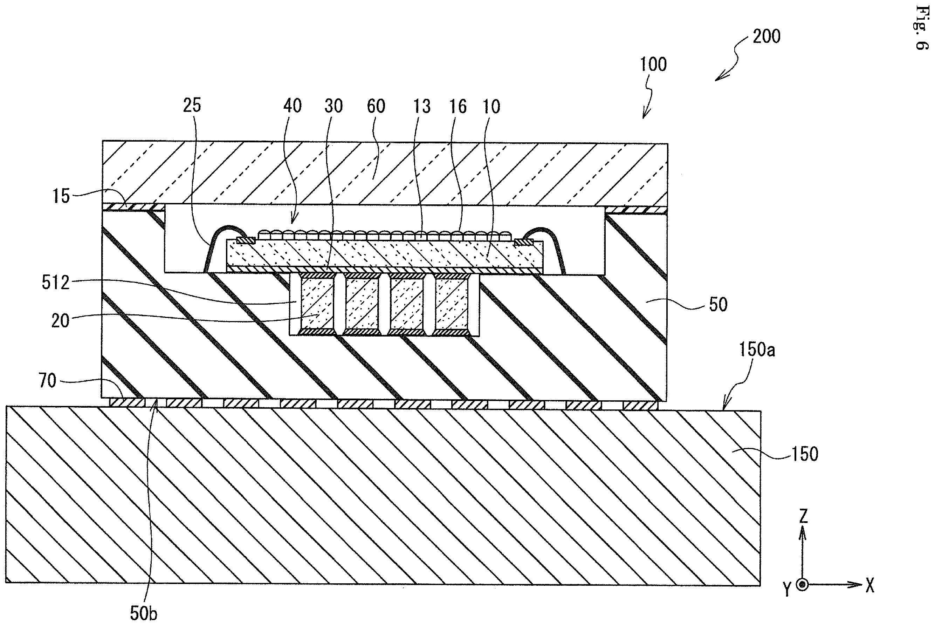

   Fig. 6 is a cross-sectional view illustrating a configuration example of a semiconductor device according to Embodiment 1 of the present disclosure.
[Fig. 7]

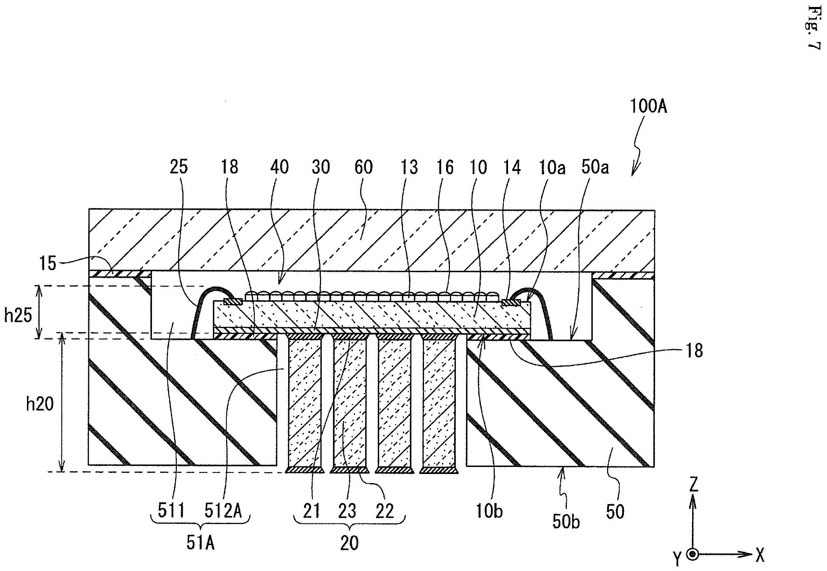

   Fig. 7 is a cross-sectional view illustrating a configuration example of the sensor package according to Embodiment 2 of the present disclosure.
[Fig. 8]

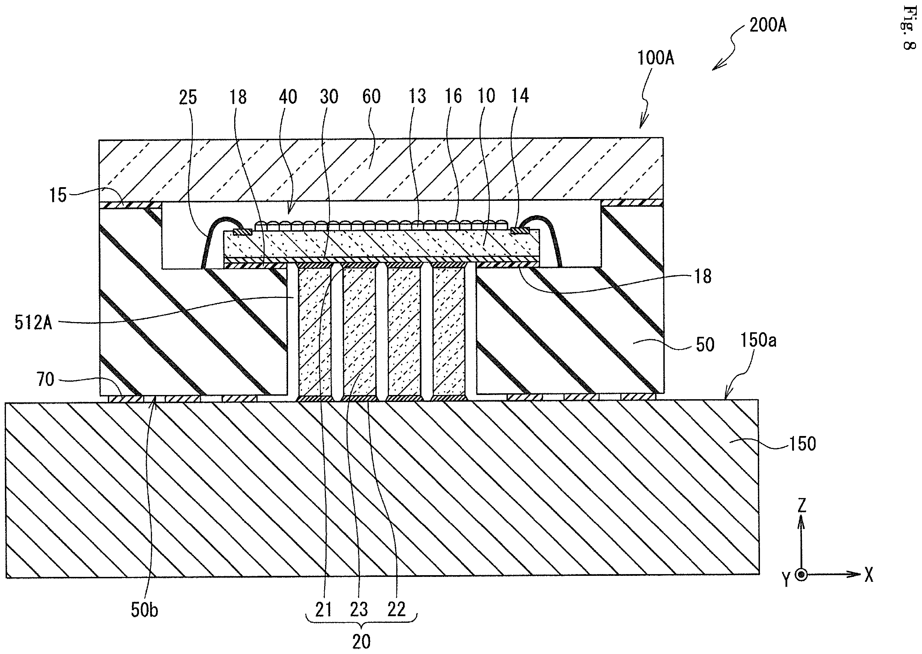

   Fig. 8 is a cross-sectional view illustrating a configuration example of the semiconductor device according to Embodiment 2 of the present disclosure.
[Fig. 9]

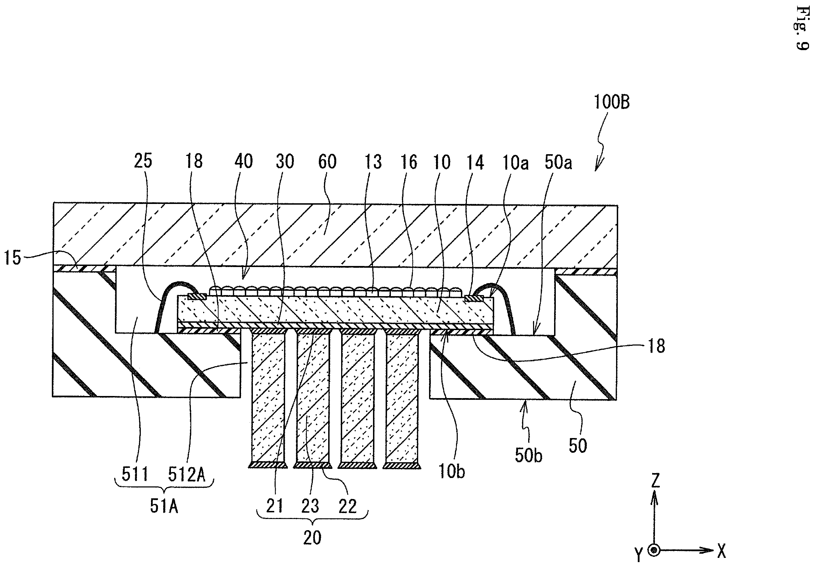

   Fig. 9 is a cross-sectional view illustrating a configuration example of the sensor package according to Embodiment 3 of the present disclosure.
[Fig. 10]

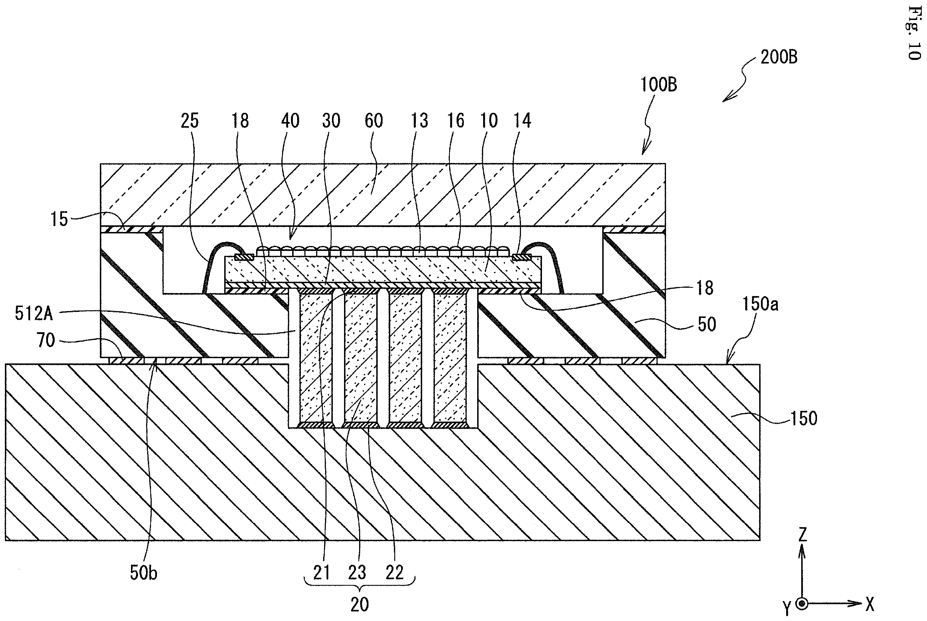

   Fig. 10 is a cross-sectional view illustrating a configuration example of the semiconductor device according to Embodiment 3 of the present disclosure.
[Fig. 11]

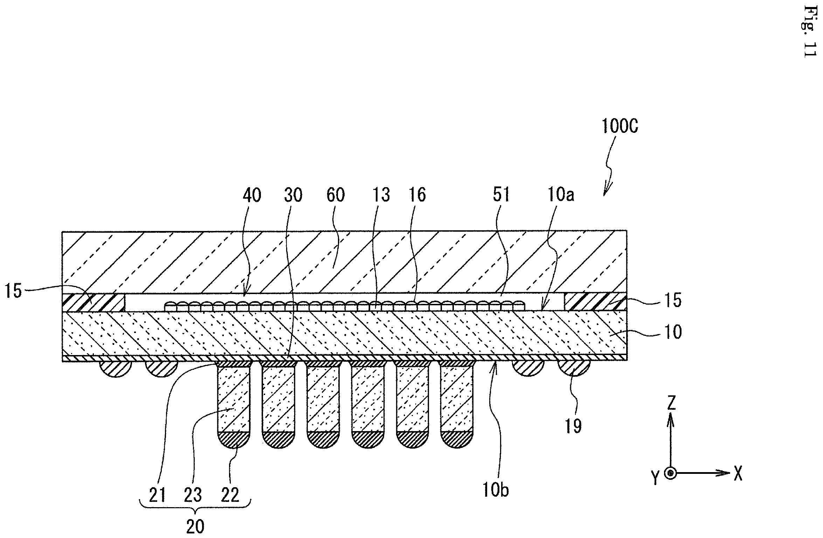

   Fig. 11 is a cross-sectional view illustrating a configuration example of the sensor package according to Embodiment 4 of the present disclosure.
[Fig. 12]

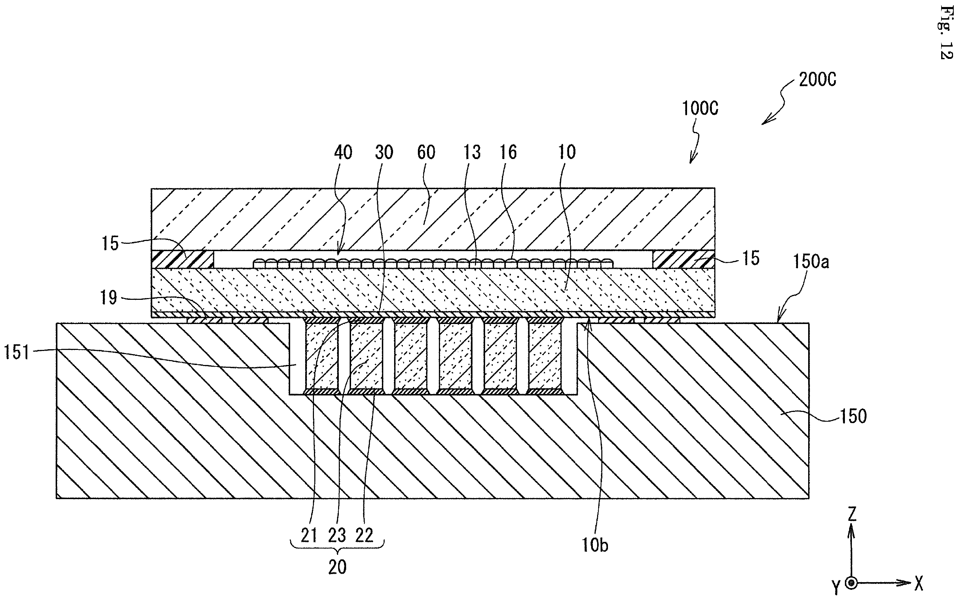

   Fig. 12 is a cross-sectional view illustrating a configuration example of the semiconductor device according to Embodiment 4 of the present disclosure.
[Fig. 13]

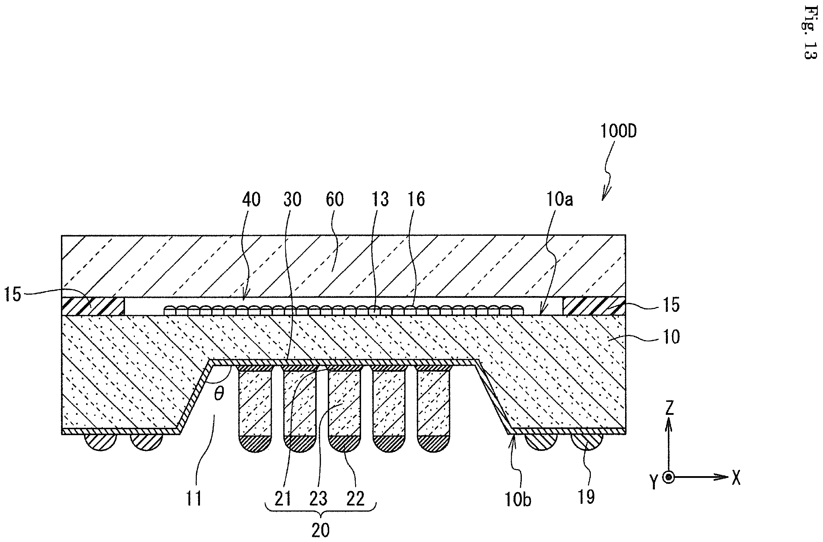

   Fig. 13 is a cross-sectional view illustrating a configuration example of the sensor package according to Embodiment 5 of the present disclosure.
[Fig. 14]

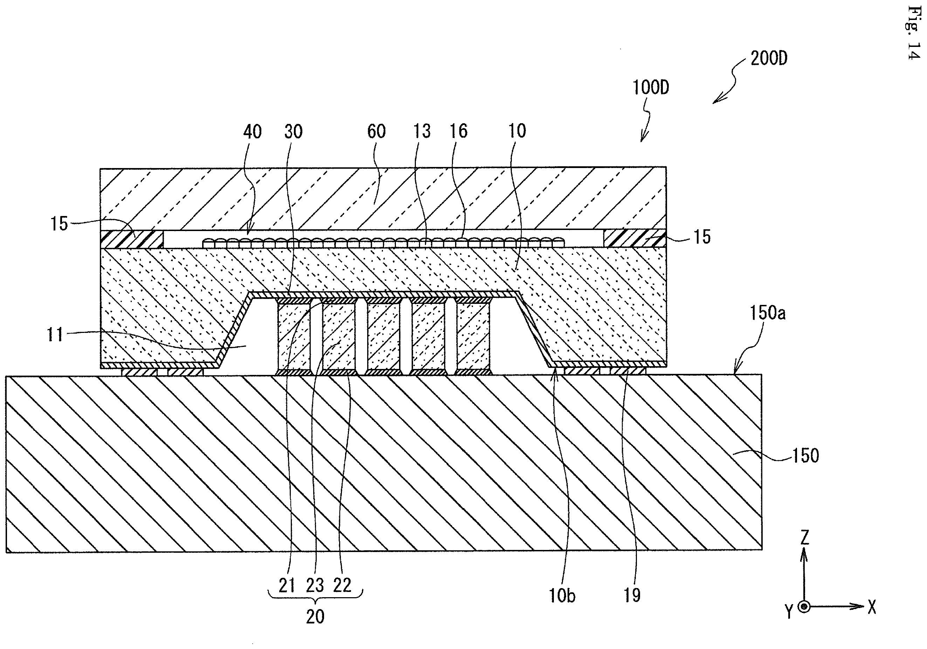

   Fig. 14 is a cross-sectional view illustrating a configuration example of the semiconductor device according to Embodiment 5 of the present disclosure.
[Fig. 15]

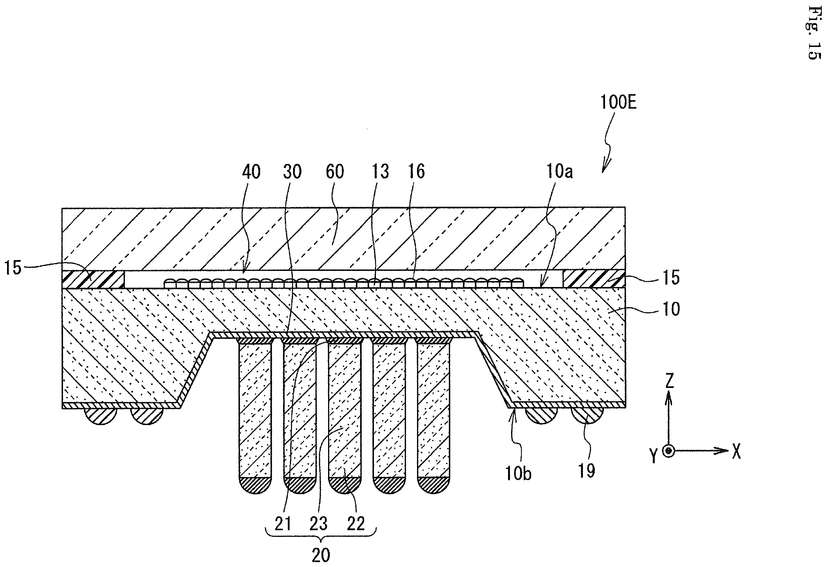

   Fig. 15 is a cross-sectional view illustrating a configuration example of the sensor package according to Embodiment 6 of the present disclosure.
[Fig. 16]

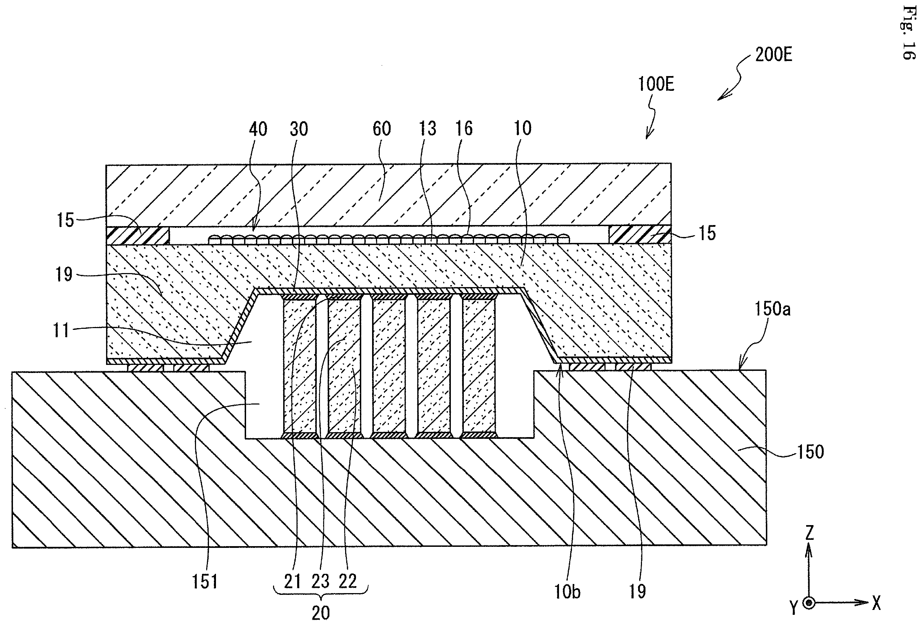

   Fig. 16 is a cross-sectional view illustrating a configuration example of the semiconductor device according to Embodiment 6 of the present disclosure.
[Fig. 17]

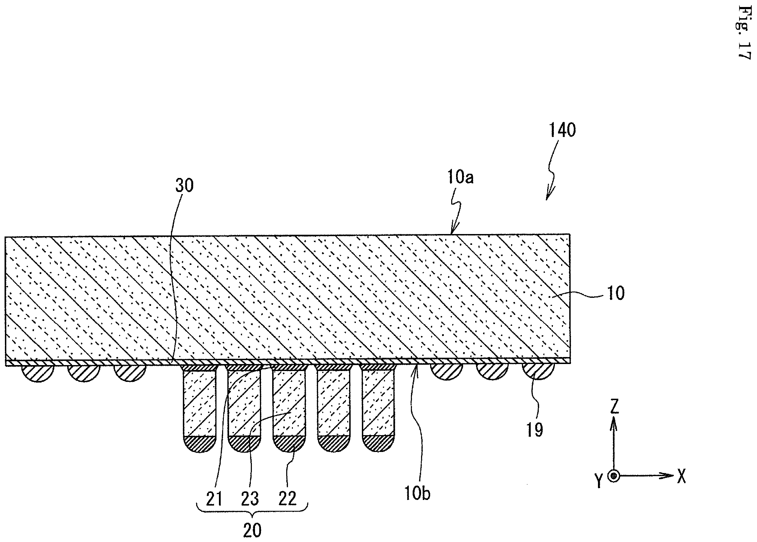

   Fig. 17 is a cross-sectional view illustrating a configuration example of an IC element to Embodiment 7 of the present disclosure.
[Fig. 18]

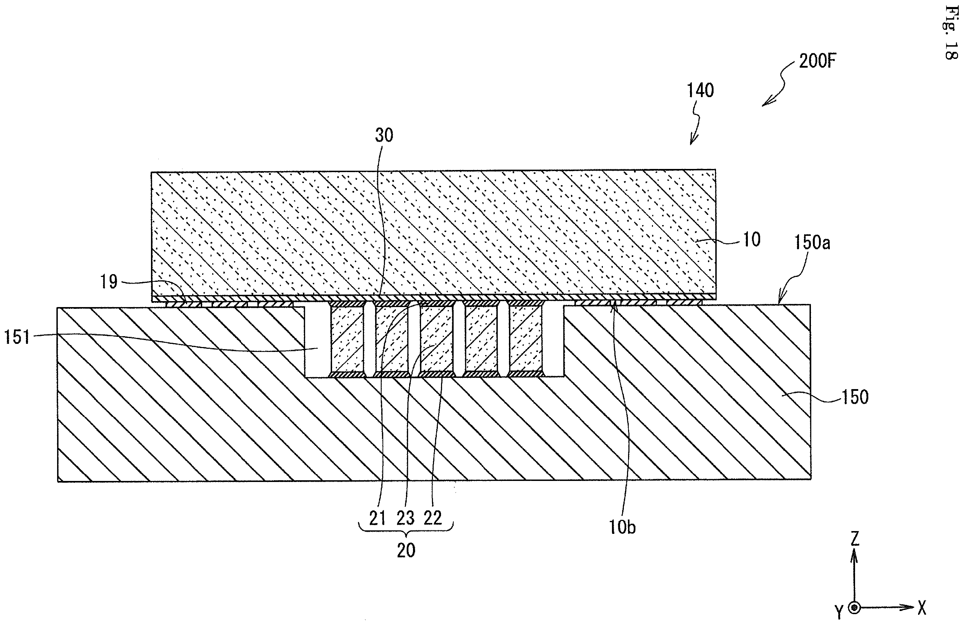

   Fig. 18 is a cross-sectional view illustrating a configuration example of the semiconductor device according to Embodiment 7 of the present disclosure.
[Fig. 19]

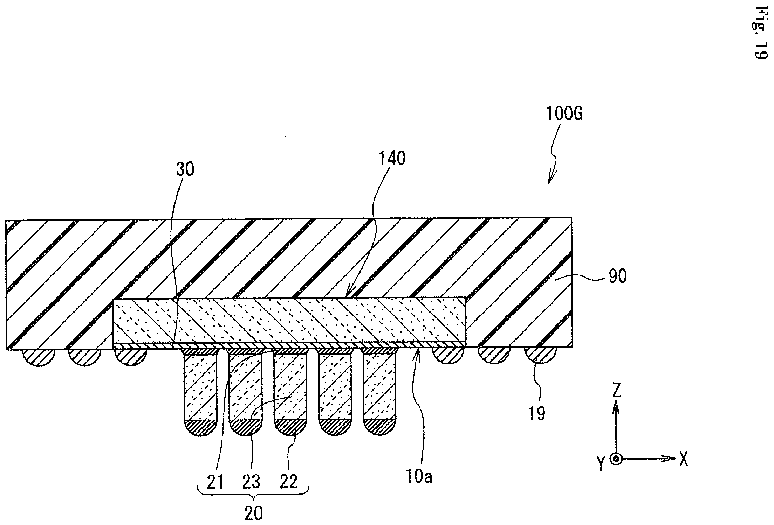

   Fig. 19 is a cross-sectional view illustrating a configuration example of an IC package according to Embodiment 8 of the present disclosure.
[Fig. 20]

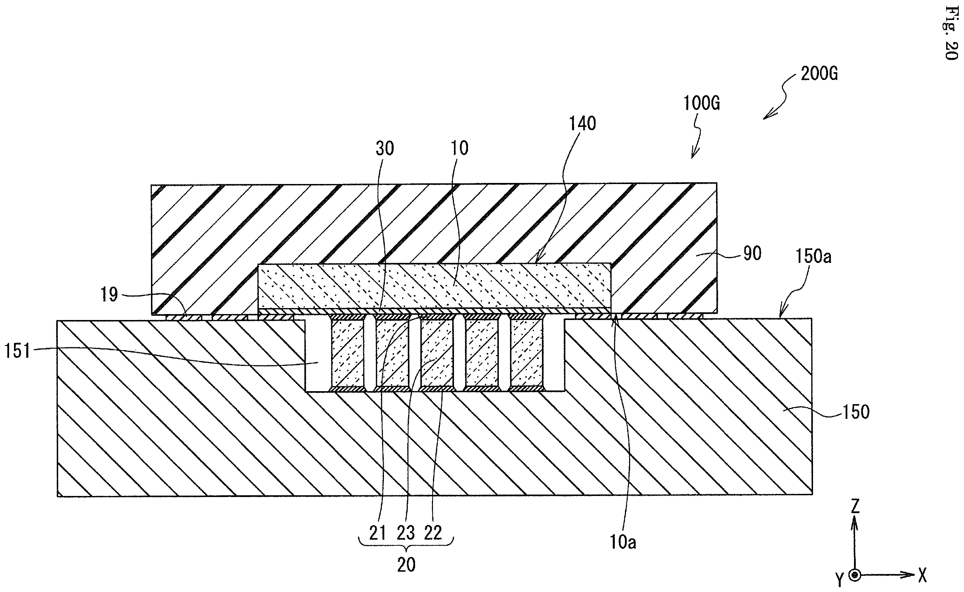

   Fig. 20 is a cross-sectional view illustrating a configuration example of the semiconductor device according to Embodiment 8 of the present disclosure.
[Fig. 21]

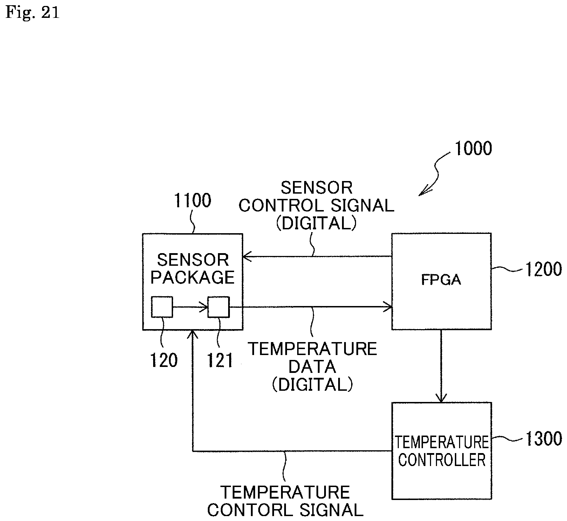

   Fig. 21 is a block diagram illustrating a schematic configuration example of an imaging system according to Embodiment 9 of the present disclosure.
[Fig. 22]

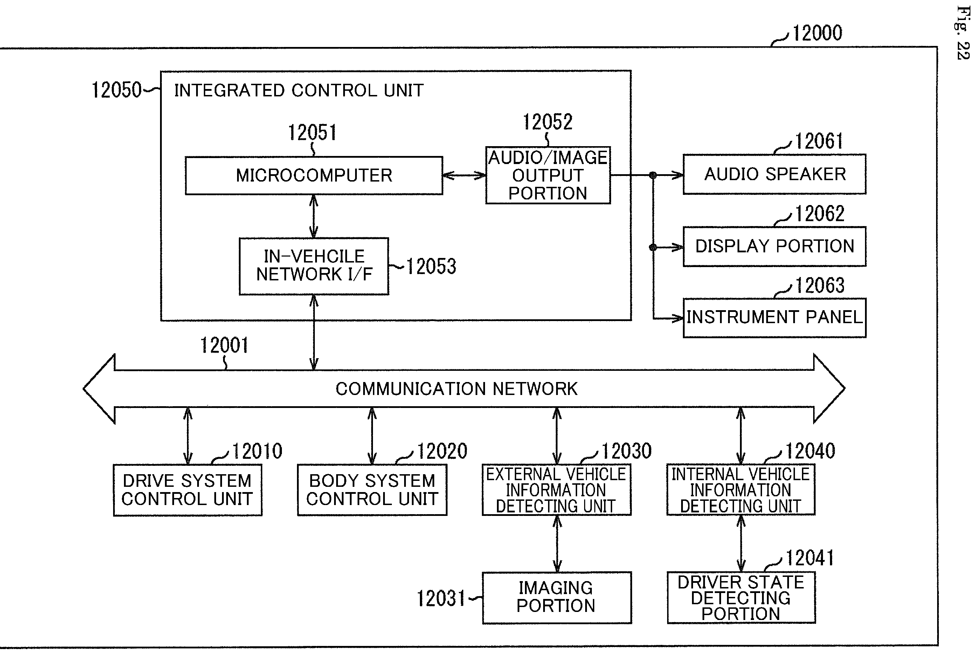

   Fig. 22 is a block diagram illustrating a schematic configuration example of a vehicle control system that is an example of a mobile object control system to which the technique according to the present disclosure may be applied.
[Fig. 23]

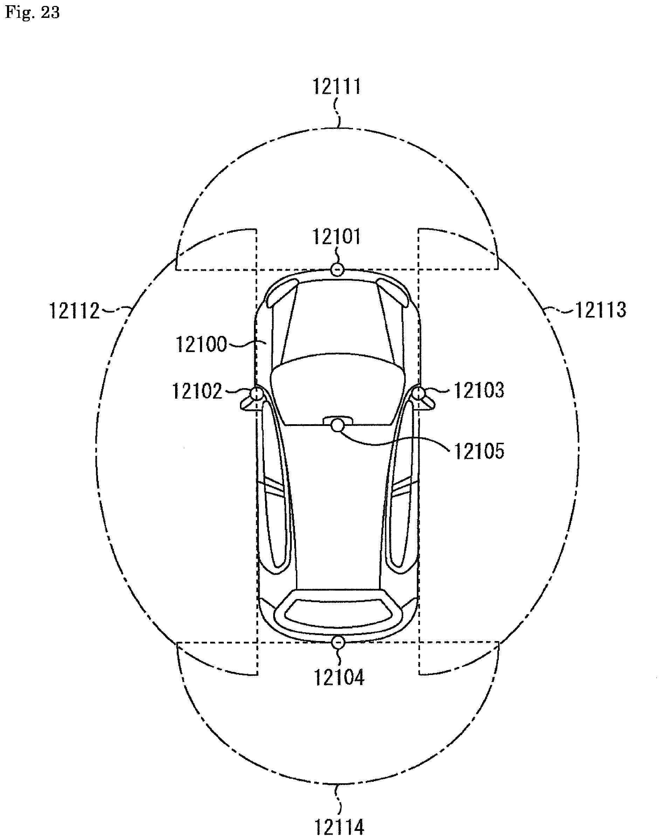

   Fig. 23 is a diagram illustrating an example of an installation position of an imaging portion.

### [Description of Embodiments]

Embodiments of the present disclosure will be described below with reference to the drawings. In descriptions of the drawings referred to in the following description, same or similar portions will be denoted by same or similar reference signs. However, it should be noted that the drawings are schematic, and the relationships between thicknesses and planar dimensions, ratios of thicknesses of respective layers, and the like are different from actual ones. Therefore, specific thicknesses and dimensions should be determined by considering the following descriptions. In addition, it is of course that the drawings include portions where mutual dimensional relationships and ratios differ between the drawings.

In addition, it is to be understood that definitions of directions such as upward and downward in the following description are merely definitions provided for the sake of brevity and are not intended to limit technical ideas of the present disclosure. For example, it is obvious that when an object is observed after being rotated by 90 degrees, up-down is converted into and interpreted as left-right, and when an object is observed after being rotated by 180 degrees, up-down is interpreted as being inverted.

Further, in the following description, a direction may be described using the words "X-axis direction," "Y-axis direction," and "Z-axis direction." For example, the Z-axis direction is a thickness direction of a semiconductor substrate 10 described later, and a normal direction of an upper surface 10a or a lower surface 10b of the semiconductor substrate 10. The X-axis direction and the Y-axis direction are directions orthogonal to the Z-axis direction. The X-axis direction, the Y-axis direction, and the Z-axis direction are orthogonal to each other. Further, in the following description, "plan view" means a view in the Z-axis direction.

### <Embodiment 1>

### (Configuration)

Fig. 1 is a plan view illustrating a configuration example of a sensor package 100 according to Embodiment 1 of the present disclosure. Fig. 2 is a cross-sectional view illustrating a configuration example of the sensor package 100 according to Embodiment 1 of the present disclosure. Fig. 2 illustrates a cross-section of the plan view illustrated in Fig. 1 cut along a line X1-X1' parallel to the X-axis direction.

As illustrated in Figs. 1 and 2, the sensor package 100 (an example of a "semiconductor device" according to the present disclosure) includes Peltier effect elements 20, sensor elements 40 (an example of "semiconductor elements" according to the present disclosure), a package substrate 50, wires 25 (an example of "wirings" according to the present disclosure) that connect the sensor elements 40 and the package substrate 50, a seal ring 15 that is provided on an upper surface 50a side of an outer circumference of the package substrate 50, and a sealing glass 60 that is bonded to the package substrate 50 with the seal ring 15 interposed therebetween. The package substrate 50, and the seal ring 15 and the sealing glass 60 constitute a package that accommodates and airtightly seals the sensor elements 40 and the Peltier effect elements 20.

The sensor element 40 is, for example, Complementary Metal Oxide Semiconductor (CMOS) image sensor or a Charge Coupled Device (CCD) image sensor. The sensor element 40 may be referred to as a sensor chip.

The sensor element 40 includes the semiconductor substrate 10, a color filter layer 13 that is provided on an upper surface 10a side of the semiconductor substrate 10 and in a pixel region, and a microlens layer 16 that is provided on the color filter layer 13. The sensor element 40 detects light by photoelectric conversion in the pixel region in which the color filter layer 13 and the microlens layer 16 are disposed. The light detected by the sensor element 40 is not limited to visible light, and may be, for example, infrared light or ultraviolet light.

The semiconductor substrate 10 is, for example, a silicon substrate. The semiconductor substrate 10 includes a photoelectric conversion element that is provided in the pixel region, a readout circuit that reads a signal charge generated by the photoelectric conversion element, a signal processing circuit that processes a signal output from the readout circuit, and the like.

The upper surface 10a (e.g., back surface) side of the semiconductor substrate 10 is provided with an inter-layer insulating film (not illustrated) or the like, and the color filter layer 13 is provided on the inter-layer insulating film. Furthermore, external connection terminals 14 are provided on the upper surface 10a side of the semiconductor substrate 10 and on an outer side of the pixel region.

A lower surface 10b (e.g., front surface) side of the semiconductor substrate 10 is provided with a rewiring layer 30. The rewiring layer 30 is a thin layer formed by a semiconductor process (e.g., Chemical Vapor Deposition (CVD) or spattering). The rewiring layer 30 has a structure that thin insulating films and thin wiring layers are alternately laminated, and the wiring layers of the respective layers have inter-layer connection via through holes (vias) or the like. The sensor element 40 is provided not on a wiring substrate that has the thickness like, for example, a rigid substrate, but on the lower surface 10b of the semiconductor substrate 10 with the thin rewiring layer 30 formed by the semiconductor process interposed therebetween.

The external connection terminals 14 are, for example, bonding pads. The external connection terminals 14 are connected to the package substrate 50 via the wires 25 such as gold wires. The external connection terminals 14 may be connected to the Peltier effect elements 20 via the wirings provided inside the semiconductor substrate 10 and the rewiring layer 30. For example, the sensor element 40 includes a pair of the external connection terminals 14. The one external connection terminal 14 of the pair of external connection terminals 14 may be used as a positive electrode side terminal that applies a positive potential to the Peltier effect element 20, and the other external connection terminal 14 may be used as a negative electrode side terminal that applies a ground potential or a negative potential to the Peltier effect element 20. When the voltage is applied between the pair of external connection terminals 14, the current flows from the one external connection terminal 14 to the other external connection terminal 14 through the Peltier effect element 20.

Fig. 3 is a plan view illustrating a configuration example of the Peltier effect element 20 according to Embodiment 1 of the present disclosure. Fig. 4 is a cross-sectional view illustrating the configuration example of the Peltier effect element 20 according to Embodiment 1 of the present disclosure. Fig. 4 illustrates a cross-section of the plan view illustrated in Fig. 3 cut along a line Y1-Y1' parallel to the Y-axis direction. The Peltier effect element 20 includes a first electrode 21, a second electrode 22, and a thermoelectric semiconductor 23. The first electrode 21 is located between the sensor element 40 and the thermoelectric semiconductor 23, and is connected to the thermoelectric semiconductor 23. The second electrode 22 is located on the side opposite to the first electrode 21 with the thermoelectric semiconductor 23 interposed therebetween, and is connected to the thermoelectric semiconductor 23.

The thermoelectric semiconductor 23 includes a p-type thermoelectric semiconductor 23p and an n-type thermoelectric semiconductor 23n. The p-type thermoelectric semiconductor 23p and the n-type thermoelectric semiconductor 23n are alternately aligned and disposed at intervals in one direction. The p-type thermoelectric semiconductor 23p and the n-type thermoelectric semiconductor 23n are alternately connected in series via the first electrode 21 and the second electrode 22.

For example, the first electrode 21 is provided between the rewiring layer 30 and the p-type thermoelectric semiconductor 23p, and between the rewiring layer 30 and the n-type thermoelectric semiconductor 23n. The first electrode 21 connects the upper end of the p-type thermoelectric semiconductor 23p and the upper end of the n-type thermoelectric semiconductor 23n. The first electrode 21 is made of copper (Cu) or a Cu film formed of a Cu alloy whose main component is Cu, and a conductive adhesive that is coated on the front surface of the Cu film. The conductive adhesive is, for example, a solder (e.g., SnAg) or silver (Ag) paste. The upper end of the p-type thermoelectric semiconductor 23p and the upper end of the n-type thermoelectric semiconductor 23n are bonded to the first electrode 21 with this conductive adhesive interposed therebetween.

The second electrode 22 is provided between the package substrate 50 and the p-type thermoelectric semiconductor 23p, and between the package substrate 50 and the n-type thermoelectric semiconductor 23n. The second electrode 22 connects the lower end of the p-type thermoelectric semiconductor 23p and the lower end of the n-type thermoelectric semiconductor 23n. The second electrode 22 is made of Cu or a Cu film formed of a Cu alloy whose main component is Cu, and a conductive adhesive that is coated on the front surface of the Cu film. The conductive adhesive is, for example, a solder (e.g., SnAg) or silver (Ag) paste. The lower end of the p-type thermoelectric semiconductor 23p and the lower end of the n-type thermoelectric semiconductor 23n are bonded to the second electrode 22 with this conductive adhesive interposed therebetween. The thicknesses of the first electrode 21 and the second electrode 22 are, for example, several ten nanometers or more to several hundred nanometers or less.

Note that the conductive films that constitute the first electrode 21 and the second electrode 22 are not limited to Cu or the Cu alloy. The first electrode 21 and the second electrode 22 may be made of, for example, a single material of titanium (Ti), tungsten (W), titanium nitride (TiN), platinum (Pt), gold (Au), germanium (Ge), palladium (Pd), zinc (Zn), nickel (Ni), or aluminum (Al), or an alloy containing at least one of these materials. Each of the first electrode 21 and the second electrode 22 may be a single film of such constituent materials, or may be a laminated film formed by combining two or more types of the constituent materials. For example, each of the first electrode 21 and the second electrode 22 may be made of a laminated film of titanium and tungsten.

Once a direct current flows from the n-type thermoelectric semiconductor 23n in the Peltier effect element 20, the semiconductor substrate 10 absorbs heat T1 (performs heat absorption), and the package substrate 50 discharges heat T2 (performs heat discharge). The Peltier effect element 20 enables heat produced in the sensor element 40 to escape to the outside of the sensor package 100 through the package substrate 50.

The package substrate 50 illustrated in Fig. 2 is a multilayer substrate formed by laminating an insulation layer and a wiring layer, and is, for example, a ceramic substrate made of alumina (or aluminum oxide) or the like, or an organic substrate made of epoxy glass. The package substrate 50 is, for example, a Pin Grid Array (PGA) substrate, may be a Ball Grid Array (BGA), or may be a Land Grid Array (LGA). An interior located between the upper surface 50a and a bottom surface 50b of the package substrate 50 is provided with multiple layers of a plurality of wirings. These wirings connect a plurality of terminals (not illustrated; e.g., solder balls) provided in the bottom surface 50b of the package substrate 50.

As illustrated in Fig. 2, the upper surface 50a side of the package substrate 50 is provided with a cavity 51. The cavity 51 includes an upper recess 511 and a lower recess 512 (an example of a "first recess" according to the present disclosure) provided on a bottom surface side of the upper recess 511. The shapes of the upper recess 511 and the lower recess 512 in plan view are, for example, rectangular shapes. The diameter of the opening plane of the upper recess 511 is greater than that of the lower recess 512.

The sensor elements 40 are disposed in the upper recess 511, and the Peltier effect elements 20 are disposed in the lower recess 512. The second electrodes 22 (see Fig. 4) of the Peltier effect elements 20 are provided on the bottom surface of the lower recess 512. The depth of the lower recess 512 is the same as or is substantially the same as heights (e.g., a height from the upper end of the first electrode 21 to the lower end of the second electrode 22) h20 of the Peltier effect elements 20 disposed in the lower recess 512. Thus, substantially all the Peltier effect elements 20 are disposed in the lower recess 512.

Furthermore, loop heights h25 of the wires 25 are lower than the heights h20 of the Peltier effect elements 20 (h25 < h20). The wire 25 has a smaller diameter and cross-sectional area than those of wires (not illustrated) provided inside the package substrate 50, and therefore has a high wiring resistance and inductance. However, by setting h25 < h20 as described above, it is possible to reduce the wiring resistance and the inductance of the wires 25. Consequently, it is possible to reduce the wiring resistance and the inductance of the wirings (e.g., a power supply wiring, a reference potential (e.g., ground potential GND) wiring, and a signal wiring) including the wires 25 among the wires included in the sensor element 40, so that it is possible to improve electrical characteristics of the sensor elements 40.

Note that a resin having the insulation property may be filled between the sensor elements 40 and the bottom surface of the lower recess 512. By filling the resin having the insulation property between the sensor elements 40 and the bottom surface of the package substrate 50, it is possible to support the Peltier effect elements 20 from a horizontal direction (a direction parallel to the X-Y plane). Consequently, it is possible to improve bonding strength of the Peltier effect elements 20 with respect to the semiconductor substrate 10 and the package substrate 50.

### (Manufacturing Method)

Next, a manufacturing method for the sensor package 100 illustrated in Figs. 1 and 2 will be described. Note, to manufacture the sensor package 100, various devices such as a device that manufactures a wafer (hereinafter, sensor wafer) 10' on which the sensor elements 40 have been multiply imposed and formed, a device that dices the sensor wafer, a device that attaches the thermoelectric semiconductor 23 to the first electrode 21 and the second electrode 22, and a wire bonding device are used. Hereinafter, these devices will be collectively referred to as a manufacturing device in the embodiments of the present disclosure. Furthermore, at least part of work performed by the manufacturing device may be performed by a worker.

Figs. 5A to 5F are cross-sectional views illustrating the manufacturing method for the sensor package 100 according to Embodiment 1 of the present disclosure. As illustrated in Fig. 5A, the manufacturing device manufactures the sensor wafer 10'. The sensor wafer 10' is the semiconductor substrate 10 on which the sensor elements 40 have been multiply imposed and formed and that is not yet diced. In the sensor wafer 10', the color filter layer 13 and the microlens layer 16 are attached to the upper surface 10a side of the semiconductor substrate 10. The rewiring layer 30 and the first electrodes 21 (see Fig. 2) are not yet formed. The rewiring layer 30 and the first electrodes 21 are formed by a process in Fig. 5C described later.

Next, as illustrated in Fig. 5B, the manufacturing device bonds the support substrate 26 on the upper surface 10a side of the semiconductor substrate 10. The support substrate 26 protects the upper surface 10a side of the semiconductor substrate 10 including the color filter layer 13 and the microlens layer 16.

Next, as illustrated in Fig. 5C, the manufacturing device turns the semiconductor substrate 10 upside down such that the lower surface 10b side of the semiconductor substrate 10 faces upward. In this state, the manufacturing device forms the rewiring layer 30 on the lower surface 10b side of the semiconductor substrate 10.

Next, the manufacturing device forms through holes (vias) H1 that penetrate between the lower surface 10b and the upper surface 10a of the semiconductor substrate 10 from the lower surface 10b side of the semiconductor substrate 10. Furthermore, the manufacturing device forms through electrodes 27 inside the through holes H1. The through electrodes 27 and the rewiring layer 30 lead part of the wirings included in the sensor elements 40 to the lower surface 10b side.

Next, as illustrated in Fig. 5C, the manufacturing device forms the first electrodes 21 of the Peltier effect elements 20 (see Fig. 2) on the lower surface 10b side of the semiconductor substrate 10. For example, the manufacturing device forms the copper (Cu) film on the lower surface 10b side of the semiconductor substrate 10 using a deposition method, a spattering method, or a CVD method. Next, the manufacturing device forms a resist pattern of a predetermined shape on the Cu film using photolithography. Next, the manufacturing device etches the Cu film using the resist pattern as a mask. Thus, the manufacturing device forms the first electrodes 21 from the Cu film. Alternatively, the manufacturing device may form the first electrodes 21 from the Cu film using a lift-off method. The manufacturing device may form the first electrodes 21 by an arbitrary method.

Next, as illustrated in Fig. 5D, the manufacturing device attaches the p-type thermoelectric semiconductors 23p and the n-type thermoelectric semiconductors 23n on the first electrodes 21. For example, the manufacturing device presses against the lower surface 10b side of the semiconductor substrate 10 a sheet to which the p-type thermoelectric semiconductors 23p and the n-type thermoelectric semiconductors 23n are adhered in advance, solders and connects the p-type thermoelectric semiconductors 23p and the n-type thermoelectric semiconductors 23n to the first electrodes 21, then removes only the sheet, and thereby attaches the p-type thermoelectric semiconductors 23p and the n-type thermoelectric semiconductors 23n on the first electrodes 21. Furthermore, the p-type thermoelectric semiconductors 23p and the n-type thermoelectric semiconductors 23n may be attached on the first electrode 21 by other methods. For example, the p-type thermoelectric semiconductor 23p and the n-type thermoelectric semiconductor 23n may be attached one by one on the first electrode 21.

Next, the manufacturing device dices (not illustrated) and singulates the sensor wafer 10' and the support substrate 26. Subsequently, the manufacturing device detaches the support substrate 26 from the upper surface 10a side of the semiconductor substrate 10.

Next, as illustrated in Fig. 5E, the manufacturing device disposes in the cavity 51 of the package substrate 50 the semiconductor substrate 10 to which the p-type thermoelectric semiconductors 23p and the n-type thermoelectric semiconductors 23n have been attached, and mounts the lower surface 10b side of the semiconductor substrate 10 on the bottom surface of the cavity 51 by solder connection.

For example, electrodes of the rewiring layer 30 provided to the semiconductor substrate 10 are soldered and connected to the bottom surface of the upper recess 511, and the p-type thermoelectric semiconductors 23p and the n-type thermoelectric semiconductors 23n are soldered and connected to the bottom surface of the lower recess 512 with the second electrodes 22 interposed therebetween. Next, as illustrated in Fig. 5D, the second electrodes 22 are provided in advance to the lower ends of the p-type thermoelectric semiconductors 23p and the n-type thermoelectric semiconductor 23n. Such solder connection fixes the positions of the semiconductor substrate 10 and the Peltier effect elements 20 in the cavity 51. Note that a conductive material used for this connection is not limited to a solder, and may be a material (e.g., Ag paste) other than the solder.

Next, as illustrated in Fig. 5F, the manufacturing device connects the external connection terminals 14 of the sensor elements 40 and the bonding pads (not illustrated) of the package substrate 50 by the wires 25. Subsequently, the manufacturing device attaches the sealing glass 60 (see Fig. 2) to the package substrate 50 by means such as the seal ring 15 (see Fig. 2) or a thermosetting adhesive in a state where the positions of the sealing glass 60 and the package substrate 50 are adjusted. Consequently, a space (i.e., cavity 51) between the sealing glass 60 and the package substrate 50 is sealed airtightly. Through the above processes, the sensor package 100 illustrated in Figs. 1 and 2 is finished.

Note that the second electrodes 22 may be provided in advance on the bottom surface of the lower recess 512 of the package substrate 50 instead of the lower ends of the p-type thermoelectric semiconductors 23p and the n-type thermoelectric semiconductors 23n. In this case, in a process in Fig. 5E, the lower ends of the p-type thermoelectric semiconductors 23p and the n-type thermoelectric semiconductors 23n are bonded to the second electrodes 22 provided in advance on the bottom surface of the lower recess 512. For this bonding, a conductive adhesive such as a solder or Ag paste may be used. Such a method can also manufacture the sensor package 100 illustrated in Figs. 1 and 2.

### (Example of Mounting on Motherboard)

Next, a semiconductor device including the sensor package 100 illustrated in Fig. 2 and mounted on a motherboard will be exemplified. Fig. 6 is a cross-sectional view illustrating a configuration example of a semiconductor device 200 according to Embodiment 1 of the present disclosure. As illustrated in Fig. 6, the semiconductor device 200 includes the sensor package 100 and a motherboard 150. The motherboard 150 is a multilayer substrate formed by laminating an insulation layer and a wiring layer, and is, for example, a ceramic substrate made of alumina (aluminum oxide) or the like or an organic substrate made of epoxy glass.

For example, the sensor package 100 is mounted on a front surface 150a of the motherboard 150. The sensor elements 40 and the Peltier effect elements 20 included in the sensor package 100 are connected to wirings of the motherboard 150 via a plurality of terminals 70 provided in the bottom surface 50b of the package substrate 50.

The plurality of terminals 70 may be, for example, ball-shaped terminals (e.g., solder balls), may be planar terminals, or may be pin-shaped terminals. In a case where the plurality of terminals 70 are the planar terminals or the pin-shaped terminals, the sensor package 100 may be attached to the motherboard 150 via a socket (not illustrated).

### (Effect of Embodiment 1)

As described above, the sensor package 100 according to Embodiment 1 of the present disclosure includes the sensor elements 40, the Peltier effect elements 20 that are attached to the lower surface 10b of the sensor elements 40 without the wiring substrate, and the package substrate 50 to which the sensor elements 40 are attached. A region of the package substrate 50 that faces the lower surface 10b of the sensor elements 40 is provided with the lower recess 512. The Peltier effect elements 20 are disposed in the lower recess 512.

Consequently, the Peltier effect elements 20 are accommodated in the lower recess 512, so that it is easy to secure the heights of the Peltier effect elements 20. It is possible to increase a distance between the lower surface 10b of the sensor elements 40 that are the heat absorption side and the bottom surface of the lower recess 512 of the package substrate 50 that is a heat discharge side, and suppress heat transfer from the heat discharge side to the heat discharge side. Consequently, it is possible to improve the cooling efficiency of the Peltier effect elements 20 of cooling the sensor elements 40.

The Peltier effect elements 20 are accommodated in the lower recess 512, so that it is possible to reduce the height of the sensor package 100 compared to a case where there is no lower recess 512. Consequently, it is possible to achieve both of improvement of the cooling efficiency for the sensor elements 40 and reduction of the height of the sensor package 100.

Furthermore, the loop heights h25 of the wires 25 are lower than the heights h20 of the Peltier effect elements 20 (h25 < h20). Consequently, it is possible to reduce the wiring resistance and the inductance of the wirings (e.g., the power supply wiring, the GND wiring, and the signal wiring) including the wires 25 among the wires included in the sensor elements 40, so that it is possible to improve the electrical characteristics of the sensor elements 40.

### <Embodiment 2>

Above Embodiment 1 has described that the Peltier effect elements 20 are disposed in the lower recess 512 of the package substrate 50. However, in the embodiments of the present disclosure, the region in which the Peltier effect elements 20 are disposed is not limited to a recess. The region in which the Peltier effect elements 20 are disposed may be a through hole.

### (Configuration)

Fig. 7 is a cross-sectional view illustrating a configuration example of a sensor package 100A according to Embodiment 2 of the present disclosure. As illustrated in Fig. 7, the package substrate 50 included in the sensor package 100A (the example of the "semiconductor device" according to the present disclosure) includes a cavity 51A. The cavity 51A includes the upper recess 511 and through holes 512A provided in the bottom surface of the upper recess 511.

The Peltier effect elements 20 are disposed in the through holes 512A of the cavity 51A. The lower ends of the Peltier effect elements 20 (e.g., the lower ends of the second electrodes 22) are located at the same height as or substantially the same height as that of the bottom surface 50b of the package substrate 50. That is, the lower ends of the Peltier effect elements 20 and the bottom surface 50b of the package substrate 50 match or substantially match in the Z-axis direction (X-Y plane). The second electrodes 22 may be, for example, the ball-shaped terminals, may be the planar terminals, or may be the pin-shaped terminals. Fig. 7 illustrates a case where the second electrodes 22 are the planar terminals.

Furthermore, an adhesive 18 is disposed between the lower surface 10b of the semiconductor substrate 10 and the bottom surface of the upper recess 511 of the cavity 51. The adhesive 18 fixes the semiconductor substrate 10 to the package substrate 50.

Next, a semiconductor device including the sensor package 100A illustrated in Fig. 7 and mounted on the motherboard will be exemplified. Fig. 8 is a cross-sectional view illustrating a configuration example of a semiconductor device 200A according to Embodiment 2 of the present disclosure. As illustrated in Fig. 8, the semiconductor device 200A includes the sensor package 100A and the motherboard 150. For example, the sensor package 100A is mounted on the front surface 150a of the motherboard 150.

The sensor elements 40 are connected to the wirings of the motherboard 150 via the plurality of terminals 70 provided in the bottom surface 50b of the package substrate 50. The Peltier effect elements 20 are connected to the wirings of the motherboard 150 via the second electrodes 22. The plurality of terminals 70 and the second electrodes 22 are connected to the wirings or the like using the conductive adhesive such as the solder or Ag paste.

Note that the second electrodes 22 of the Peltier effect elements 20 may be provided in advance on the front surface 150a of the motherboard 150 instead of the lower ends of the p-type thermoelectric semiconductors 23p and the n-type thermoelectric semiconductors 23n. For example, the second electrodes 22 may be provided in advance on the front surface 150a as part of the wirings of the motherboard 150.

### (Effect of Embodiment 2)

As described above, the sensor package 100A according to Embodiment 2 of the present disclosure includes the sensor elements 40, the Peltier effect elements 20 that are attached to the lower surface 10b of the sensor elements 40 without the wiring substrate, and the package substrate 50 to which the sensor elements 40 are attached. The region of the package substrate 50 that faces the lower surface 10b of the sensor elements 40 is provided with the through holes 512A. The Peltier effect elements 20 are disposed in the through holes 512A.

Consequently, Embodiment 2 provides the same effect as that of Embodiment 1. That is, the Peltier effect elements 20 are accommodated in the through hole 512A, so that it is easy to secure the heights of the Peltier effect elements 20. Consequently, it is possible to improve the cooling efficiency of the Peltier effect elements 20 of cooling the sensor elements 40.

The Peltier effect elements 20 are accommodated in the through holes 512A, so that it is possible to reduce the height of the sensor package 100. It is possible to achieve both of improvement of the cooling efficiency for the sensor elements 40 and reduction of the height of the sensor package 100.

As illustrated in Fig. 7, in Embodiment 2, too, the loop heights h25 of the wires 25 are lower than the heights h20 of the Peltier effect elements 20 (h25 < h20). Consequently, it is possible to reduce the wiring resistance and the inductance of the wirings (e.g., the power supply wiring, the GND wiring, and the signal wiring) including the wires 25, so that it is possible to improve the electrical characteristics of the sensor elements 40.

### <Embodiment 3>

Above Embodiment 2 has described that the lower ends of the Peltier effect elements 20 disposed in the through holes 512A of the cavity 51 and the bottom surface 50b of the package substrate 50 match or substantially match in the Z-axis direction. However, in the embodiments of the present disclosure, the Peltier effect elements 20 may protrude from the bottom surface 50b of the package substrate 50.

### (Configuration)

Fig. 9 is a cross-sectional view illustrating a configuration example of a sensor package 100B according to Embodiment 3 of the present disclosure. As illustrated in Fig. 9, the sensor package 100B (the example of the "semiconductor device" according to the present disclosure), the lower portions of the thermoelectric semiconductors 23 and the second electrodes 22 of the Peltier effect elements 20 protrude from the bottom surface 50b of the package substrate 50. In this example, too, the second electrodes 22 may be, for example, the ball-shaped terminals, may be the planar terminals, or may be the pin-shaped terminals. Fig. 9 illustrates a case where the second electrodes 22 are the planar terminals.

Next, a semiconductor device including the sensor package 100B illustrated in Fig. 9 and mounted on the motherboard will be exemplified. Fig. 10 is a cross-sectional view illustrating a configuration example of a semiconductor device 200B according to Embodiment 3 of the present disclosure. As illustrated in Fig. 10, the semiconductor device 200B (the example of the "semiconductor device" according to the present disclosure) includes the sensor package 100B, and the motherboard 150. For example, the sensor package 100B is mounted on the front surface 150a of the motherboard 150. A front surface 150a side of the motherboard 150 is provided with a recess 151 (an example of a "third recess" according to the present disclosure). The lower portions and the second electrodes 22 of the Peltier effect elements 20 protruding from the bottom surface 50b of the package substrate 50 are disposed in the recess 151 of the motherboard 150.

The second electrodes 22 of the Peltier effect elements 20 are connected to wirings or the like provided in the bottom surface of the recess 151 of the motherboard 150. The second electrodes 22 are connected to the wirings or the like using the conductive adhesive such as the solder or Ag paste.

### (Effect of Embodiment 3)

As described above, the semiconductor device 200B according to Embodiment 3 of the present disclosure includes the sensor package 100B, and the motherboard 150 to which the package substrate 50 of the sensor package 100B is attached. The motherboard 150 is provided with the recess 151 that faces the through holes 512A of the package substrate 50. The Peltier effect elements 20 are disposed in the through holes 512A and the recess 151.

Consequently, Embodiment 3 provides the same effect as that of Embodiments 1 and 2. That is, the Peltier effect elements 20 are accommodated in the through holes 512A of the package substrate 50 and the recess 151 of the motherboard 150, so that it is easy to secure the heights of the Peltier effect elements 20. Consequently, it is possible to improve the cooling efficiency of the Peltier effect elements 20 of cooling the sensor elements 40.

The Peltier effect elements 20 are accommodated in the through holes 512A of the package substrate 50 and the recess 151 of the motherboard 150, so that it is possible to reduce the height of the semiconductor device 200B including the sensor package 100B. It is possible to achieve both of improvement of the cooling efficiency for the sensor elements 40 and reduction of the height of the semiconductor device 200B.

### <Embodiment 4>

Above Embodiments 1 to 3 have described that the sensor packages 100, 100A, and 100B include the package substrate 50. However, in the embodiments of the present disclosure, the configuration of the sensor package is not limited thereto. In the embodiments of the present disclosure, the package format of the sensor package may employ a configuration from which the package substrate 50 is omitted, and may be, for example, a Wafer Level Chip Size Package (WLCSP).

### (Configuration)

Fig. 11 is a cross-sectional view illustrating a configuration example of a sensor package 100C according to Embodiment 4 of the present disclosure. As illustrated in Fig. 11, the package format of the sensor package 100C is, for example, a WLCSP. The WLCSP is, for example, a package formed by exposing part of a semiconductor substrate (a diced wafer) without performing wiring using bonding wires. The WLCSP is a package formed by substantially reducing the size of the Ball Grid Array (BGA) to the same size as that of a sensor chip. It is possible to provide an effect of reduction of the weight, the thickness, and the length of electronic devices such as digital cameras and mobile telephones.

The lower surface 10b side of the semiconductor substrate 10 is provided with external connection terminals 19 of the WLCSP and the Peltier effect elements 20 with the rewiring layer 30 interposed therebetween. Note that, although FIG. 11 illustrates a case where the external connection terminals 19 and the second electrodes 22 of the Peltier effect elements 20 are the ball-shaped terminals (e.g., solder balls), this case is merely an example. The external connection terminals 19 of the WLCSP and the second electrodes 22 of the Peltier effect elements 20 may be the planar terminals.

Next, a semiconductor device including the sensor package 100C illustrated in Fig. 11 and mounted on the motherboard will be exemplified. Fig. 12 is a cross-sectional view illustrating a configuration example of a semiconductor device 200C according to Embodiment 4 of the present disclosure.

As illustrated in Fig. 12, the semiconductor device 200C (the example of the "semiconductor device" according to the present disclosure) includes the sensor package 100C whose package format is the WLCSP, and the motherboard 150. For example, the sensor package 100C is mounted on the front surface 150a of the motherboard 150. The front surface 150a side of the motherboard 150 is provided with the recess 151. The Peltier effect elements 20 provided on a lower surface side of the sensor package 100C are disposed in the recess 151 of the motherboard 150.

The second electrodes 22 of the Peltier effect elements 20 are connected to the wirings or the like provided in the bottom surface of the recess 151 of the motherboard 150. The second electrodes 22 are connected to the wirings or the like using the conductive adhesive such as the solder or Ag paste.

The external connection terminals 19 of a sensor package 100D are connected to wirings or the like provided on the front surface 150a side of the motherboard 150 and in a region other than the recess 151.

### (Effect of Embodiment 4)

The semiconductor device 200C according to Embodiment 4 of the present disclosure includes the sensor elements 40, the Peltier effect elements 20 that are attached to the lower surface 10b of the sensor elements 40 without the wiring substrate, and the motherboard 150 that faces the sensor elements 40 with the Peltier effect elements 20 interposed therebetween. The motherboard 150 is provided with the recess 151. The Peltier effect elements 20 are disposed in the recess 151.

Consequently, Embodiment 4 provides the same effect as that of Embodiments 1 to 3. That is, the Peltier effect elements 20 are accommodated in the recess 151 of the motherboard 150, so that it is easy to secure the heights of the Peltier effect elements 20. Consequently, it is possible to improve the cooling efficiency for the sensor elements 40.

The Peltier effect elements 20 are accommodated in the recess 151 of the motherboard 150, so that it is possible to reduce the height of the semiconductor device 200C. It is possible to achieve both of improvement of the cooling efficiency for the sensor elements 40 and reduction of the height of the semiconductor device 200C.

The package format of the sensor package 100C is, for example, a WLCSP. Consequently, it is possible to narrow pitches of the power supply terminal, the GND terminal, and the signal terminal of the sensor package 100C (miniaturize the package).

### <Embodiment 5>

### (Configuration)

Fig. 13 is a cross-sectional view illustrating a configuration example of a sensor package 100D according to Embodiment 5 of the present disclosure. A difference of the sensor package 100D (the example of the "semiconductor device" according to the present disclosure) illustrated in Fig. 13 from the sensor package 100C illustrated in Fig. 11 is that a recess 11 (an example of a "second recess" according to the present disclosure) is provided on the lower surface 10b side of the semiconductor substrate 10. The Peltier effect elements 20 are disposed in the recess 11.

The first electrodes 21 of the Peltier effect elements 20 are connected to the rewiring layer 30 in the bottom surface (the upper surface in Fig. 13) of the recess 11. The depth of the recess 11 is the same as or is substantially the same as the heights of the Peltier effect elements 20 disposed in the lower recess 11. Consequently, the second electrodes 22 of the Peltier effect elements 20 and the external connection terminals 19 of the sensor package 100D match or substantially match in the Z-axis direction (X-Y plane).

Note that, in a case where a silicon material whose substrate surface is <100> is used for the semiconductor substrate 10, and a KOH aqueous solution is used to form the recess 11, the silicon material is subjected to anisotropic etching and the side surfaces of the recess 11 are formed as surfaces inclined with respect to the bottom surface. An angle θ of these inclined surfaces is 125.3°. Consequently, it is easy to form the rewiring layer 30 on the side surfaces of the recess 11 compared to a case of, for example, θ = 90°. As illustrated in Fig. 13, it is easy to form the rewiring layer 30 having the uniform thickness from the outer side of the recess 11 to the bottom surface of the recess 11.

Next, a semiconductor device including the sensor package 100D illustrated in Fig. 13 and mounted on the motherboard will be exemplified. Fig. 14 is a cross-sectional view illustrating a configuration example of a semiconductor device 200D according to Embodiment 5 of the present disclosure.

As illustrated in Fig. 14, the semiconductor device 200D includes the sensor package 100D and the motherboard 150. For example, the sensor package 100D is mounted on the front surface 150a of the motherboard 150.

The external connection terminals 19 of the sensor package 100D and the second electrodes 22 of the Peltier effect elements 20 are connected to the wirings or the like provided on the front surface 150a side of the motherboard 150. The external connection terminals 19 and the second electrodes 22 are connected to the wirings or the like using the conductive adhesive such as the solder or Ag paste.

### (Effect of Embodiment 5)

The sensor package 100D according to Embodiment 5 of the present disclosure includes the sensor elements 40, and the Peltier effect elements 20 that are attached to the lower surface 10b of the sensor elements 40 without the wiring substrate. The recess 11 is provided in the lower surface 10b of sensor elements 40. The Peltier effect elements 20 are disposed in the recess 11.

Consequently, Embodiment 5 provides the same effect as that of Embodiments 1 to 4. That is, the Peltier effect elements 20 are accommodated in the recess 11 of the sensor elements 40, so that it is easy to secure the heights of the Peltier effect elements 20. Consequently, it is possible to improve the cooling efficiency for the sensor elements 40.

The Peltier effect elements 20 are accommodated in the recess 11 of the sensor elements 40, so that it is possible to reduce the height of the sensor package 100D. It is possible to achieve both of improvement of the cooling efficiency for the sensor elements 40 and reduction of the height of the sensor package 100D.

The package format of the semiconductor device 200D is, for example, the WLCSP. Consequently, it is possible to narrow pitches of the power supply terminal, the GND terminal, and the signal terminal of the sensor package 100D (miniaturize the package).

### <Embodiment 6>

### (Configuration)

Fig. 15 is a cross-sectional view illustrating a configuration example of a sensor package 100E according to Embodiment 6 of the present disclosure. A difference of the sensor package 100E (the example of the "semiconductor device" according to the present disclosure) illustrated in Fig. 15 from the sensor package 100D illustrated in Fig. 13 is that part of the Peltier effect elements 20 protrude from the lower surface 10b of the semiconductor substrate 10.

In the sensor package 100D, the lower portions of the thermoelectric semiconductors 23 and the second electrodes 22 of the Peltier effect elements 20 protrude from the lower surface 10b of the semiconductor substrate 10. Fig. 15 illustrates a case where the second electrodes 22 are the ball-shaped terminals (e.g., solder balls). However, the second electrodes 22 are not limited to the ball-shaped terminals, and may be, for example, the planar terminals.

Fig. 16 is a cross-sectional view illustrating a configuration example of a semiconductor device 200E according to Embodiment 6 of the present disclosure. As illustrated in Fig. 16, the semiconductor device 200E (the example of the "semiconductor device" according to the present disclosure) includes the sensor package 100E and the motherboard 150. For example, the sensor package 100E is mounted on the front surface 150a of the motherboard 150. The front surface 150a side of the motherboard 150 is provided with the recess 151.

The lower portions of the Peltier effect elements 20 and the second electrodes 22 protruding from the lower surface 10b of the semiconductor substrate 10 are disposed in the recess 151 of the motherboard 150.

The second electrodes 22 of the Peltier effect elements 20 are connected to the wirings or the like provided in the bottom surface of the recess 151 of the motherboard 150. The second electrodes 22 are connected to the wirings or the like using the conductive adhesive such as the solder or Ag paste.

### (Effect of Embodiment 6)

The semiconductor device 200E according to Embodiment 6 of the present disclosure includes the sensor package 100E, and the motherboard 150 to which the sensor package 100E is attached. The motherboard 150 is provided with the recess 151 that faces the recess 11 of the lower surface 10b of the sensor elements 40. The Peltier effect elements 20 are disposed in the recess 11 and in the recess 151.

Consequently, Embodiment 6 provides the same effect as that of Embodiments 1 to 5.

That is, the Peltier effect elements 20 are accommodated in the recess 11 and in the recess 151, so that it is easy to secure the heights of the Peltier effect elements 20. Consequently, it is possible to improve the cooling efficiency of the Peltier effect elements 20 of cooling the sensor elements 40.

The Peltier effect elements 20 are disposed in the recess 11 and in the recess 151, so that it is possible to reduce the height of the semiconductor device 200E including the sensor package 100E. It is possible to achieve both of improvement of the cooling efficiency for the sensor elements 40 and reduction of the height of the semiconductor device 200E.

### <Embodiment 7>

The semiconductor elements according to the present disclosure are not limited to the semiconductor elements. The semiconductor elements according to the present disclosure may be, for example, various IC elements such as Large Scale Integrated (LSI) circuits or memory elements.

### (Configuration)

Fig. 17 is a cross-sectional view illustrating a configuration example of an IC element 140 according to Embodiment 7 of the present disclosure. The IC element 140 illustrated in Fig. 17 is, for example, an LSI element, and a package format thereof is the WLCSP.

The lower surface 10b side of the semiconductor substrate 10 is provided with the external connection terminals 19 of the WLCSP and the Peltier effect elements 20 with the rewiring layer 30 interposed therebetween. Note that, although FIG. 17 illustrates a case where the external connection terminals 19 and the second electrodes 22 of the Peltier effect elements 20 are the ball-shaped terminals (e.g., solder balls), this case is merely an example. The external connection terminals 19 of the WLCSP and the second electrodes 22 of the Peltier effect elements 20 may be the planar terminals.

Fig. 18 is a cross-sectional view illustrating a configuration example of a semiconductor device 200F according to Embodiment 7 of the present disclosure. As illustrated in Fig. 18, the semiconductor device 200F (the example of the "semiconductor device" according to the present disclosure) includes the IC element 140 and the motherboard 150. For example, the IC element 140 is mounted on the front surface 150a of the motherboard 150. The front surface 150a side of the motherboard 150 is provided with the recess 151. The Peltier effect elements 20 provided on the lower surface 10b side of the IC element 140 are disposed in the recess 151 of the motherboard 150.

The second electrodes 22 of the Peltier effect elements 20 are connected to the wirings or the like provided in the bottom surface of the recess 151 of the motherboard 150. The second electrodes 22 are connected to the wirings or the like using the conductive adhesive such as the solder or Ag paste.

Furthermore, the external connection terminals 19 of the IC element 140 are connected to wirings or the like provided on the front surface 150a side of the motherboard 150 and in a region other than the recess 151.

### (Effect of Embodiment 7)

The semiconductor device 200F according to Embodiment 7 of the present disclosure includes the IC element 140, the Peltier effect elements 20 that are attached to the lower surface 10b of the IC elements 140 without the wiring substrate, and the motherboard 150 that faces the IC element 140 with the Peltier effect elements 20 interposed therebetween. The motherboard 150 is provided with the recess 151. The Peltier effect elements 20 are disposed in the recess 151.

Consequently, Embodiment 7 provides the same effect as that of Embodiments 1 to 6.

That is, the Peltier effect elements 20 are accommodated in the recess 151 of the motherboard 150, so that it is easy to secure the heights of the Peltier effect elements 20. Consequently, it is possible to improve the cooling efficiency for the IC element 140.

The Peltier effect elements 20 are accommodated in the recess 151 of the motherboard 150, so that it is possible to reduce the height of the semiconductor device 200F. It is possible to achieve both of improvement of the cooling efficiency for the IC element 140 and reduction of the height of the semiconductor device 200F.

The IC element 140 is the WLCSP. Consequently, it is possible to narrow pitches of the power supply terminal, the GND terminal, and the signal terminal of the IC element 140 (miniaturize the package).

### <Embodiment 8>

Above Embodiment 7 has described a case where the IC element 140 is mounted on the motherboard in a bare state. However, in the embodiments of the present disclosure, the IC element 140 may be sealed with a resin.

### (Configuration)

Fig. 19 is a cross-sectional view illustrating a configuration example of an IC package 100G according to Embodiment 8 of the present disclosure. As illustrated in Fig. 19, the IC package 100G includes the IC element 140, and a sealing resin 90 that seals the upper surface 10a (e.g., back surface) and the side surfaces of the IC element 140. A package format of the IC package 100G is, for example, a Fan Out Wafer Level Package (FOWLP) or a Fan Out Panel Level Package (FOPLP). A material of the sealing resin 90 is an epoxy resin, a phenol resin, or the like.

As illustrated in Fig. 19, the lower surface 10b (e.g., front surface) side of the semiconductor substrate 10 is provided with the external connection terminals 19 of the IC package 100G and the Peltier effect elements 20 with the rewiring layer 30 interposed therebetween. Note that, although FIG. 19 illustrates a case where the external connection terminals 19 and the second electrodes 22 of the Peltier effect elements 20 are the ball-shaped terminals (e.g., solder balls), this case is merely an example. The external connection terminals 19 and the second electrodes 22 of the Peltier effect elements 20 may be the planar terminals.

Fig. 20 is a cross-sectional view illustrating a configuration example of a semiconductor device 200G according to Embodiment 8 of the present disclosure. As illustrated in Fig. 20, the semiconductor device 200F (the example of the "semiconductor device" according to the present disclosure) includes the IC package 100G whose package format is the FOWLP or the FOPLP, and the motherboard 150. For example, the IC package 100G is mounted on the front surface 150a of the motherboard 150. The front surface 150a side of the motherboard 150 is provided with the recess 151. The Peltier effect elements 20 provided on a lower surface side of the IC package 100G are disposed in the recess 151 of the motherboard 150.

The second electrodes 22 of the Peltier effect elements 20 are connected to the wirings or the like provided in the bottom surface of the recess 151 of the motherboard 150. The second electrodes 22 are connected to the wirings or the like using the conductive adhesive such as the solder or Ag paste.

The external connection terminals 19 of the IC package 100G are connected to wirings or the like provided on the front surface 150a side of the motherboard 150 and in a region other than the recess 151.

### (Effect of Embodiment 8)

Embodiment 8 provides the same effect as that of Embodiments 1 to 7. That is, the Peltier effect elements 20 are accommodated in the recess 151 of the motherboard 150, so that it is easy to secure the heights of the Peltier effect elements 20. Consequently, it is possible to improve the cooling efficiency for the IC element 140.

The Peltier effect elements 20 are accommodated in the recess 151 of the motherboard 150, so that it is possible to reduce the height of the semiconductor device 200G. It is possible to achieve both of improvement of the cooling efficiency for the IC element 140 and reduction of the height of the semiconductor device 200G.

The package format of the IC package 100G is, a FOWLP or a FOPLP. Consequently, it is possible to narrow pitches of the power supply terminal, the GND terminal, and the signal terminal of the IC package 100G (miniaturize the package).

### <Embodiment 9>

Fig. 21 is a block diagram illustrating a schematic configuration example of an imaging system according to Embodiment 9 of the present disclosure. As illustrated in Fig. 21, an imaging system 1000 according to Embodiment 9 of the present disclosure includes a sensor package 1100, a Field-Programmable Gate Array (FPGA) 1200, and a temperature controller 1300.

To the sensor package 1100, for example, one of the semiconductor devices 200 to 100G described in Embodiments 1 to 8 is applied.

The FPGA 1200 is, for example, a control device for controlling the sensor package 1100. The FPGA 1200 inputs a control signal for controlling the sensor package 1100 to the sensor package 1100 via the pin-shaped terminal or the like. As an interface that connects the FPGA 1200 and the sensor package 1100, an Inter-Integrated Circuit (I2C), a Serial Peripheral Interface (SPI), or the like can be used. Note that an information processing device such as an Image Signal Processor (ISP) may be used instead of the FPGA 1200.

The sensor package 1100 includes, for example, a thermometer circuit 120 and an AD conversion circuit 121. Temperature data (detection result) detected by the thermometer circuit 120 and converted into a digital value by the AD conversion circuit 121 is output to the FPGA 1200 via, for example, the same interface as an interface such as the I2C or the SPI that connects the FPGA 1200 and the sensor package 1100. In the present embodiment, a dedicated line or a dedicated terminal for outputting the temperature data to an outside of the sensor package can be omitted.

The temperature controller 1300 controls the Peltier effect elements 20 according to, for example, a control signal from the FPGA 1200. More specifically, the temperature controller 1300 forms a current waveform to be given to the Peltier effect elements 20 according to the control signal from the FPGA 1200, and supplies the current waveform to the Peltier effect elements 20 via the pin-shaped terminals or the like.

According to the above configuration, the thermometer circuit 120 is disposed inside the sensor package 1100, so that it is possible to directly measure the temperature of the sensor package 1100 itself. Consequently, it is possible to enhance accuracy of the measured sensor chip temperature.

Furthermore, for example, an analog value output from the thermometer circuit 120 is converted into a digital value by the AD conversion circuit 121 in the sensor package 1100, so that it is possible to reduce an influence of noise of the measurement result detected by the thermometer circuit 120. Consequently, it is possible to enhance robustness of the measured temperature.

Furthermore, by converting a measurement result into a digital value, it is possible to output a measurement result to the outside of the sensor package using a control signal of the I2C, the SPI, or the like. It is not necessary to provide a dedicated terminal for outputting the measurement result to the outside of the sensor package. Consequently, it is possible to output the measurement result to the outside without restriction of the number of terminals on the sensor package.

Furthermore, a separate part is not attached to the sensor package 1100 unlike a discrete thermistor element, so that it is also possible to suppress a decrease in a yield rate due to a failure of the thermistor element, an attachment failure, or the like.

### <Other Embodiments>

While the present disclosure has been described on the basis of the embodiments and modifications as described above, the descriptions and figures that constitute parts of the present disclosure should not be understood as limiting the present disclosure. Various alternative embodiments, examples, and operable techniques will be apparent to those skilled in the art from the present disclosure. It is needless to say that the present technique includes various embodiments that are not described here. Various constituent elements can be omitted, replaced, and/or changed without departing from the essential spirit of the above-described embodiments and variations. Furthermore, the effects described in the present description are merely exemplary and not intended to be limiting, and other effects may be provided as well.

### <Application to Mobile Object>

The technology of the present disclosure (the present technology) can be applied to various products. For example, the technique according to the present disclosure may be realized as a device mounted on any type of moving body such as an automobile, an electric automobile, a hybrid electric automobile, a motorcycle, a bicycle, a personal mobility device, an airplane, a drone, a ship, a robot, or the like.

Fig. 22 is a block diagram illustrating a schematic configuration example of a vehicle control system, which is an example of a moving body control system to which the technique according to the present disclosure can be applied.

The vehicle control system 12000 includes a plurality of electronic control units connected thereto via a communication network 12001. In the example illustrated in Fig. 22, the vehicle control system 12000 includes a drive system control unit 12010, a body system control unit 12020, an external vehicle information detecting unit 12030, an internal vehicle information detecting unit 12040, and an integrated control unit 12050. In addition, as a functional configuration of the integrated control unit 12050, a microcomputer 12051, an audio/image output portion 12052, and an in-vehicle network interface (I/F) 12053 are illustrated.

The drive system control unit 12010 controls an operation of an apparatus related to a drive system of a vehicle according to various programs. For example, the drive system control unit 12010 functions as a driving force generator for generating a driving force of a vehicle such as an internal combustion engine or a driving motor, a driving force transmission mechanism for transmitting a driving force to wheels, a steering mechanism for adjusting a turning angle of a vehicle, and a control apparatus such as a braking apparatus that generates a braking force of a vehicle.

The body system control unit 12020 controls operations of various devices mounted in the vehicle body according to various programs. For example, the body system control unit 12020 functions as a control device of a keyless entry system, a smart key system, a power window device, or various lamps such as a headlamp, a back lamp, a brake lamp, a turn signal, and a fog lamp. In this case, radio waves transmitted from a portable device that substitutes for a key or signals of various switches may be input to the body system control unit 12020. The body system control unit 12020 receives inputs of the radio waves or signals and controls a door lock device, a power window device, and a lamp of the vehicle.

The external vehicle information detecting unit 12030 detects information on the outside of the vehicle having the vehicle control system 12000 mounted thereon. For example, an imaging portion 12031 is connected to the external vehicle information detecting unit 12030. The external vehicle information detecting unit 12030 causes the imaging portion 12031 to capture an image of the outside of the vehicle and receives the captured image. The external vehicle information detecting unit 12030 may perform object detection processing or distance detection processing for peoples, cars, obstacles, signs, and letters on the road on the basis of the received image.

The imaging portion 12031 is an optical sensor that receives light and outputs an electrical signal according to the amount of the received light. The imaging portion 12031 can also output the electrical signal as an image or distance measurement information. In addition, the light received by the imaging portion 12031 may be visible light or invisible light such as infrared light.

The internal vehicle information detecting unit 12040 detects information on the inside of the vehicle. For example, a driver state detecting unit 12041 that detects a driver's state is connected to the internal vehicle information detecting unit 12040. The driver state detecting unit 12041 includes, for example, a camera that captures an image of a driver, and the internal vehicle information detecting unit 12040 may calculate a degree of fatigue or concentration of the driver or may determine whether or not the driver is dozing on the basis of detection information input from the driver state detecting unit 12041.

The microcomputer 12051 can calculate a control target value of the driving force generation device, the steering mechanism, or the braking device on the basis of the information on the outside or the inside of the vehicle acquired by the external vehicle information detecting unit 12030 or the internal vehicle information detecting unit 12040 and output a control command to the drive system control unit 12010. For example, the microcomputer 12051 can perform cooperative control for the purpose of obtaining functions of an Advanced Driver Assistance System (ADAS) including collision avoidance or impact mitigation of a vehicle, following traveling based on inter-vehicle distance, vehicle speed maintenance driving, vehicle collision warning, vehicle lane deviation warning, or the like.

Further, the microcomputer 12051 can perform cooperative control for the purpose of automated driving or the like in which autonomous travel is performed without depending on operations of the driver, by controlling the driving force generator, the steering mechanism, or the braking device and the like on the basis of information about the surroundings of the vehicle, the information being acquired by the external vehicle information detecting unit 12030 or the internal vehicle information detecting unit 12040.

In addition, the microcomputer 12051 can output a control command to the body system control unit 12020 based on the information acquired by the external vehicle information detecting unit 12030 outside the vehicle. For example, the microcomputer 12051 can perform cooperative control for the purpose of preventing glare, such as switching from a high beam to a low beam, by controlling the headlamp according to the position of a preceding vehicle or an oncoming vehicle detected by the external vehicle information detecting unit 12030.

The audio/image output portion 12052 transmits an output signal of at least one of sound and an image to an output device capable of visually or audibly notifying a passenger or the outside of the vehicle of information. In the example of Fig. 22, an audio speaker 12061, a display portion 12062, and an instrument panel 12063 are illustrated as examples of the output device. The display portion 12062 may include at least one of an on-board display and a head-up display, for example.

Fig. 23 is a diagram illustrating an example of an installation position of the imaging portion 12031.

In Fig. 23, a vehicle 12100 includes imaging portions 12101, 12102, 12103, 12104, and 12105 as the imaging portion 12031.

The imaging portions 12101, 12102, 12103, 12104, and 12105 are provided at positions such as a front nose, side-view mirrors, a rear bumper, a back door, and an upper portion of a windshield in a vehicle interior of the vehicle 12100, for example. The imaging portion 12101 provided on the front nose and the imaging portion 12105 provided in the upper portion of the windshield in the vehicle interior mainly acquire images of the front of the vehicle 12100. The imaging portions 12102 and 12103 provided on the side-view mirrors mainly acquire images of a lateral side of the vehicle 12100. The imaging portion 12104 provided on the rear bumper or the back door mainly acquires images of the rear of the vehicle 12100. Front view images acquired by the imaging portions 12101 and 12105 are mainly used for detection of preceding vehicles, pedestrians, obstacles, traffic lights, traffic signs, lanes, and the like.

Fig. 23 illustrates an example of imaging ranges of the imaging portions 12101 to 12104.

An imaging range 12111 indicates an imaging range of the imaging portion 12101 provided at the front nose, imaging ranges 12112 and 12113 respectively indicate the imaging ranges of the imaging portions 12102 and 12103 provided at the side-view mirrors, and an imaging range 12114 indicates the imaging range of the imaging portion 12104 provided at the rear bumper or the back door. For example, by superimposing image data captured by the imaging portions 12101 to 12104, it is possible to obtain a bird's-eye view image viewed from the upper side of the vehicle 12100.

At least one of the imaging portions 12101 to 12104 may have a function for obtaining distance information. For example, at least one of the imaging portions 12101 to 12104 may be a stereo camera constituted by a plurality of imaging elements or may be an imaging element that has pixels for phase difference detection.

For example, the microcomputer 12051 can extract, particularly, the closest three-dimensional object on a path along which the vehicle 12100 is traveling, which is a three-dimensional object traveling at a predetermined speed (for example, 0 km/h or higher) in the substantially same direction as the vehicle 12100, as a vehicle ahead by acquiring a distance to each three-dimensional object in the imaging ranges 12111 to 12114 and a temporal change of this distance (a relative speed with respect to the vehicle 12100) on the basis of the distance information obtained from the imaging portions 12101 to 12104. Furthermore, the microcomputer 12051 can set an inter-vehicle distance to be secured from a vehicle ahead in advance with respect to the vehicle ahead and can perform automated brake control (also including following stop control) or automated acceleration control (also including following start control). In this way, cooperative control can be performed for the purpose of automated traveling or the like in which a vehicle automatedly travels without the operations of the driver.

For example, the microcomputer 12051 can classify and extract three-dimensional data regarding three-dimensional objects into two-wheeled vehicles, normal vehicles, large vehicles, pedestrians, and other three-dimensional objects such as electric poles based on distance information obtained from the imaging portions 12101 to 12104 and can use the three-dimensional data to perform automated avoidance of obstacles. For example, the microcomputer 12051 differentiates surrounding obstacles of the vehicle 12100 into obstacles which can be viewed by the driver of the vehicle 12100 and obstacles which are difficult to view. Then, the microcomputer 12051 determines a collision risk indicating the degree of risk of collision with each obstacle, and when the collision risk is equal to or higher than a set value and there is a possibility of collision, an alarm is output to the driver through the audio speaker 12061 or the display portion 12062, forced deceleration or avoidance steering is performed through the drive system control unit 12010, and thus it is possible to perform driving support for collision avoidance.

At least one of the imaging portions 12101 to 12104 may be an infrared camera that detects infrared rays. For example, the microcomputer 12051 can recognize a pedestrian by determining whether there is a pedestrian in the captured image of the imaging portions 12101 to 12104. Such pedestrian recognition is performed by, for example, a procedure in which feature points in the captured images of the imaging portions 12101 to 12104 as infrared cameras are extracted and a procedure in which pattern matching processing is performed on a series of feature points indicating an outline of an object to determine whether or not the object is a pedestrian. When the microcomputer 12051 determines that there is a pedestrian in the captured images of the imaging portions 12101 to 12104 and the pedestrian is recognized, the audio/image output portion 12052 controls the display portion 12062 so that a square contour line for emphasis is superimposed and displayed with the recognized pedestrian. In addition, the audio/image output portion 12052 may control the display portion 12062 so that an icon indicating a pedestrian or the like is displayed at a desired position.

An example of the vehicle control system to which the technology according to the present disclosure can be applied has been described above. The technique according to the present disclosure may be applied to the imaging portion 12031 and the like among the above-described configurations. For example, one of the semiconductor devices 200 to 200G described in Embodiments 1 to 8, or the imaging system described in Embodiment 9 are applicable to the imaging portion 12031.

By applying the technique according to the present disclosure, it is possible to improve, for example, the cooling efficiency of the sensor element 40, and obtain a high-quality photographed image, so that the moving body control system can perform accurate control using the photographed image. Alternatively, by applying the technology according to the present disclosure, for example, it is possible to improve the cooling efficiency for the sensor elements 40, reduce noise or the like caused by the temperature, and obtain a clearer photographed image, so that it is possible to reduce a driver's fatigue.

Note that the present disclosure can also be configured as follows.
(1) A semiconductor device includes:
   a semiconductor element;
   a Peltier effect element that is attached to a first surface of the semiconductor element without a wiring substrate; and
   a package substrate to which the semiconductor element is attached, and
   a region of the package substrate facing the first surface of the semiconductor element is provided with a first recess or a through hole, and
   the Peltier effect element is disposed in the first recess or in the through hole.
(2) In the semiconductor device described in above (1), the first surface of the semiconductor element is provided with a second recess that faces the first recess or the through hole of the package substrate, and
   the Peltier effect element is disposed in the first recess or the through hole and in the second recess.
(3) The semiconductor device described in above (1) or (2) further includes a motherboard to which the package substrate is attached,
   the motherboard is provided with a third recess that faces the through hole of the package substrate, and
   the Peltier effect element is disposed in the through hole and in the third recess.
(4) A semiconductor device includes:
   a semiconductor element; and
   a Peltier effect element that is attached to a first surface of the semiconductor element without a wiring substrate,
   the first surface of the semiconductor element is provided with a second recess, and the Peltier effect element is disposed in the second recess.
(5) The semiconductor device described in above (4) further includes a motherboard to which the semiconductor element is attached,
   the motherboard is provided with a third recess that faces the second recess of the semiconductor element, and
   the Peltier effect element is disposed in the second recess and in the third recess.
(6) A semiconductor device includes:
   a semiconductor element;
   a Peltier effect element that is attached to a first surface of the semiconductor element without a wiring substrate; and
   a motherboard that faces the semiconductor element with the Peltier effect element interposed therebetween,
   the motherboard is provided with a third recess, and
   the Peltier effect element is disposed in the third recess.
(7) The semiconductor device described in any one of above (1) to (6) further includes a conductive adhesive that bonds the Peltier effect element and the first surface of the semiconductor element.
(8) In the semiconductor device described in above (7), the conductive adhesive is a solder or silver paste.
(9) In the semiconductor device described in any one of above (1) to (8), the Peltier effect element includes
   a thermoelectric semiconductor,
   a first electrode that is located between the thermoelectric semiconductor and the semiconductor element and is connected to the thermoelectric semiconductor, and a second electrode that is located on a side opposite to the first electrode with the thermoelectric semiconductor interposed therebetween and is connected to the thermoelectric semiconductor, and
   the first electrode is provided on the first surface.
(10) The semiconductor device described in any one of above (1) to (3) further includes a wiring that connects the semiconductor element and the package substrate, and a height of the wiring is lower than a height of the Peltier effect element.
(11) In the semiconductor device described in any one of above (1) to (3) and (10), the package substrate is a ceramic substrate or an organic substrate.
(12) In the semiconductor device described in any one of above (3), (5), and (6), the motherboard is a ceramic substrate or an organic substrate.
(13) In the semiconductor device described in any one of above (4) to (6), a package format of the semiconductor element is a Wafer Level Chip Scale Package (WLCSP).
(14) In the semiconductor device described in any one of above (1) to (13), the semiconductor element is a sensor element or an IC element.

### [Reference Signs List]

10 Semiconductor substrate
10' Sensor wafer
10a, 50a Upper surface
10b Lower surface
11 Recess
13 Color filter layer
14, 19 External connection terminal
15 Seal ring
16 Microlens layer
18 Adhesive
20 Peltier effect element
21 First electrode
22 Second electrode
23 Thermoelectric semiconductor
23n n-type thermoelectric semiconductor
23p p-type thermoelectric semiconductor
25 Wire
26 Support substrate
27 Through electrode
30 Rewiring layer
40 Sensor element
50 Package substrate
50b Bottom surface
51, 51A Cavity
60 Sealing glass
70 Terminal
90 Sealing resin
100, 100A, 100B, 100C, 100D, 100E, 100G IC package
120 Thermometer circuit
121 AD conversion circuit
140 IC element
150 Motherboard
150a Front surface
151 Recess
200, 200A, 200B, 200C, 200D, 200E, 200F, 200G Semiconductor device 511 Upper recess
512 Lower recess
512A Through hole
1000 Imaging system
1100 Sensor package
1300 Temperature controller
12000 Vehicle control system
12001 Communication network
12010 Drive system control unit
12020 Body system control unit
12030 External vehicle information detecting unit
12031 Imaging portion
12040 Internal vehicle information detecting unit
12041 Driver state detecting portion
12050 Integrated control unit
12051 Microcomputer
12052 Audio/image output portion
12061 Audio speaker
12062 Display portion
12063 Instrument panel
12100 Vehicle
12101, 12102, 12103, 12104 to 12105 Imaging portion
12111, 12112, 12113, 12114 Imaging range
H1 Through hole

## Claims

1. A semiconductor device comprising:
a semiconductor element;
a Peltier effect element that is attached to a first surface of the semiconductor element without a wiring board; and
a package substrate to which the semiconductor element is attached, wherein
a region of the package substrate facing the first surface of the semiconductor element is provided with a first recess or a through hole, and
the Peltier effect element is disposed in the first recess or in the through hole.

2. The semiconductor device according to claim 1, wherein
the first surface of the semiconductor element is provided with a second recess that faces the first recess or the through hole of the package substrate, and
the Peltier effect element is disposed in the first recess or the through hole and in the second recess.

3. The semiconductor device according to claim 1, further comprising a motherboard to which the package substrate is attached, wherein
the motherboard is provided with a third recess that faces the through hole of the package substrate, and
the Peltier effect element is disposed in the through hole and in the third recess.

4. A semiconductor device includes:
a semiconductor element;
a Peltier effect element that is attached to a first surface of the semiconductor element without a wiring substrate, wherein
the first surface of the semiconductor element is provided with a second recess, and
the Peltier effect element is disposed in the second recess.

5. The semiconductor device according to claim 4, further comprising a motherboard to which the semiconductor element is attached, wherein
the motherboard is provided with a third recess that faces the second recess of the semiconductor element, and
the Peltier effect element is disposed in the second recess and in the third recess.

6. A semiconductor device comprising:
a semiconductor element;
a Peltier effect element that is attached to a first surface of the semiconductor element without a wiring substrate; and
a motherboard that faces the semiconductor element with the Peltier effect element interposed therebetween, wherein
the motherboard is provided with a third recess, and
the Peltier effect element is disposed in the third recess.

7. The semiconductor device according to claim 1, further comprising a conductive adhesive that bonds the Peltier effect element and the first surface of the semiconductor element.

8. The semiconductor device according to claim 7, wherein the conductive adhesive is a solder or silver paste.

9. The semiconductor device according to claim 1, wherein
the Peltier effect element includes
a thermoelectric semiconductor,
a first electrode that is located between the thermoelectric semiconductor and the semiconductor element and is connected to the thermoelectric semiconductor, and
a second electrode that is located on a side opposite to the first electrode with the thermoelectric semiconductor interposed therebetween and is connected to the thermoelectric semiconductor, and
the first electrode is provided on the first surface.

10. The semiconductor device according to claim 1, further comprising a wiring that connects the semiconductor element and the package substrate,
wherein a height of the wiring is lower than a height of the Peltier effect element.

11. The semiconductor device according to claim 1, wherein the package substrate is a ceramic substrate or an organic substrate.

12. The semiconductor device according to claim 3, wherein the motherboard is a ceramic substrate or an organic substrate.

13. The semiconductor device according to claim 4, wherein a package format of the semiconductor element is a Wafer Level Chip Scale Package (WLCSP).

14. The semiconductor device according to claim 1, wherein the semiconductor element is a sensor element or an IC element.
